# EUROPEAN PATENT APPLICATION

(11) **EP 4 845 382 A1**
(43) Date of publication of application: **25.11.2026**
(21) Application number: 26150681.0
(22) Date of filing: 07.01.2026
(51) Int. Cl.: H10W 90/20, H10W 90/00, H10W 20/00, H10W 20/20, H10W 20/40

(54) **SEMICONDUCTOR DEVICE INCLUDING THROUGH-VIA AND METHOD OF MANUFACTURING THE SAME**

(30) Priority: 22.05.2025 KR 20250066879
(71) Applicant: Samsung Electronics Co., Ltd., Suwon-si, Gyeonggi-do 16677 (KR)
(72) Inventor: KIM, Deokhwan, 16677 Suwon-si (KR); KANG, Hoyoung, 16677 Suwon-si (KR); KO, Kyungyong, 16677 Suwon-si (KR); LEE, Kyoungwoo, 16677 Suwon-si (KR); LEE, Minseung, 16677 Suwon-si (KR); LEE, Junhee, 16677 Suwon-si (KR); HWANG, Jegwan, 16677 Suwon-si (KR)
(74) Representative: Marks & Clerk LLP

(57) **Abstract**

There are provided a semiconductor device including a through-electrode of which the size is reduced without reduction in resistance so that the thickness of the semiconductor device is reduced and a method of manufacturing the same. The semiconductor device includes a first semiconductor chip including a first semiconductor substrate, a first integrated device layer, and a first wiring layer and a second semiconductor chip stacked on the first semiconductor chip and including a second semiconductor substrate, a second integrated device layer, a second wiring layer, and a through-electrode. The second semiconductor chip includes a device isolation layer isolating the second integrated device layer. The through-electrode passes through the device isolation layer. A level of a bottom surface of the through-electrode is higher than or substantially the same as a level of a bottom surface of the device isolation layer.

## Description

### BACKGROUND

The disclosed concepts relate to a semiconductor device, and more particularly, to a semiconductor device including a through-electrode and a method of manufacturing a semiconductor device.

Integrated circuit (IC) chip manufacturing is a complex, multistep process of forming electronic circuits on a wafer including a semiconductor material (for example, silicon (Si)). IC chip manufacturing may be divided into a front-end-of-line (FEOL) process and a back-end-of-line (BEOL) process. In the FEOL process, integrated devices such as transistors are formed in a wafer, and in the BEOL process, a wiring layer is formed on an integrated device layer. In addition, the BEOL process may include forming a through silicon via (TSV). The TSV is a vertical connection electrode completely passing through a silicon wafer or die. The TSV may be used to create a three-dimensional (3D) semiconductor package and a 3D integrated circuit.

### SUMMARY

The disclosed concepts relate to a semiconductor device including a through-electrode of which the size is reduced without reduction in resistance so that the thickness of the semiconductor device is reduced and a method of manufacturing the same.

The technical problems of the disclosed concepts are not limited to the technical problems mentioned above, and other technical problems not mentioned will be clearly understood by those skilled in the art from the description below.

According to aspects of the disclosed concepts, there is provided a semiconductor device including a through-electrode. The semiconductor device includes a first semiconductor chip including a first semiconductor substrate, a first integrated device layer, and a first wiring layer and a second semiconductor chip stacked on the first semiconductor chip and including a second semiconductor substrate, a second integrated device layer, a second wiring layer, and a through-electrode. The second semiconductor chip includes a device isolation layer isolating the second integrated device layer. The through-electrode passes through the device isolation layer. A level of a bottom surface of the through-electrode is higher than or substantially the same as a level of a bottom surface of the device isolation layer.

According to aspects of the disclosed concepts, there is provided a semiconductor device including a through-electrode. The semiconductor device includes a first semiconductor substrate, a first integrated device layer on the first semiconductor substrate, a first wiring layer on the first integrated device layer, a device isolation layer isolating the first integrated device layer, and a through-electrode passing through the device isolation layer. A level of a bottom surface of the through-electrode is higher than or substantially the same as a level of a bottom surface of the device isolation layer.

According to aspects of the disclosed concepts, there is provided a semiconductor device including a through-electrode. The semiconductor device includes a first semiconductor substrate, a first integrated device layer on the first semiconductor substrate, a first wiring layer on the first integrated device layer, a hybrid copper bonding (HCB) structure on the first wiring layer, a second semiconductor substrate on the HCB structure, a second integrated device layer on the second semiconductor substrate, a second wiring layer on the second integrated device layer, a device isolation layer isolating the second integrated device layer, and a through-electrode passing through the device isolation layer. A level of a bottom surface of the through-electrode is higher than or substantially the same as a level of a bottom surface of the device isolation layer.

According to another aspect of the inventive concept, there is provided a method of manufacturing a semiconductor device, including preparing a first wafer including a first semiconductor substrate, a first integrated device layer, a first wiring layer, and a device isolation layer, forming a through-hole in the device isolation layer, forming a through-electrode in the through-hole, removing a lower portion of the first semiconductor substrate, forming a first insulating layer under the first semiconductor substrate, forming a recess exposing a lower portion of the through-electrode in the first insulating layer, forming a contact metal layer in the recess, and forming a pad redistribution layer connected to the contact metal layer and a first pad.

In embodiments of the inventive concept, in the forming of the through-hole, the first semiconductor substrate may be used as an etching stop layer. In embodiments of the inventive concept, in the forming of the through-hole, the at least one through-hole may be formed in the one device isolation layer. In embodiments of the inventive concept, the forming of the through-electrode may include coating the through-hole with a barrier metal and forming a metal electrode layer on the barrier metal in the through-hole. In embodiments of the inventive concept, before the coating of the through-hole with the barrier metal, coating the through-hole with an insulating liner may be further included.

In embodiments of the inventive concept, in the removing of the lower portion of the first semiconductor substrate, a lower portion of the first semiconductor substrate is removed through a grinding and chemical mechanical polishing (CMP) process and the device isolation layer may be used as an etching stop layer. In embodiments of the inventive concept, the recess may expose a bottom surface of the through-electrode and a side surface adjacent to the bottom surface of the through-electrode. The contact metal layer may surround the bottom surface of the through-electrode and the side surface adjacent to the bottom surface of the through-electrode.

In embodiments of the inventive concept, completing a first device wafer through the forming of the pad redistribution layer and a first pad and bonding a second device wafer to the first device wafer may be further included. In embodiments of the inventive concept, the second device wafer may include a second semiconductor substrate, a second integrated device layer, and a second wiring layer. A first protective layer surrounding the first pad may be arranged under the pad redistribution layer. A second pad and a second protective layer surrounding the second pad may be arranged on the second wiring layer. In the bonding of the second device wafer to the first device wafer, the first pad may be combined with the second pad and the first protective layer may be combined with the second protective layer. In embodiments of the inventive concept, in the forming of the pad redistribution layer and the first pad, a back-side power delivery network (BSPDN) layer may be formed under the first semiconductor substrate.

At least some of the above and other features of the invention are set out in the claims.

### BRIEF DESCRIPTION OF THE DRAWINGS

Embodiments will be more clearly understood from the following detailed description taken in conjunction with the accompanying drawings in which:
FIG. 1 is a cross-sectional view of a semiconductor device according to embodiments;
FIG. 2 is a conceptual diagram for comparing the size of a through-electrode of the semiconductor device of FIG. 1 with the size of a through-electrode of a semiconductor device of a comparative example;
FIG. 3 is a cross-sectional view of a semiconductor device according to embodiments;
FIGS. 4A to 4D are cross-sectional views of semiconductor devices according to embodiments;
FIG. 5 is a cross-sectional view of a semiconductor device according to embodiments;
FIG. 6 is a cross-sectional view of a semiconductor device according to embodiments;
FIG. 7 is a cross-sectional view of a semiconductor device according to embodiments;
FIGS. 8A and 8B are cross-sectional views of semiconductor packages including semiconductor devices according to embodiments;
FIGS. 9A and 9B are perspective and cross-sectional views of a system package including a semiconductor package according to embodiments; and
FIGS. 10A to 10I are cross-sectional views schematically illustrating processes of a method of manufacturing a semiconductor device according to embodiments.

### DETAILED DESCRIPTION

Hereinafter, embodiments of the inventive concept will be described in detail with reference to the accompanying drawings.

Like reference numerals refer to like elements, and their repetitive descriptions are omitted.

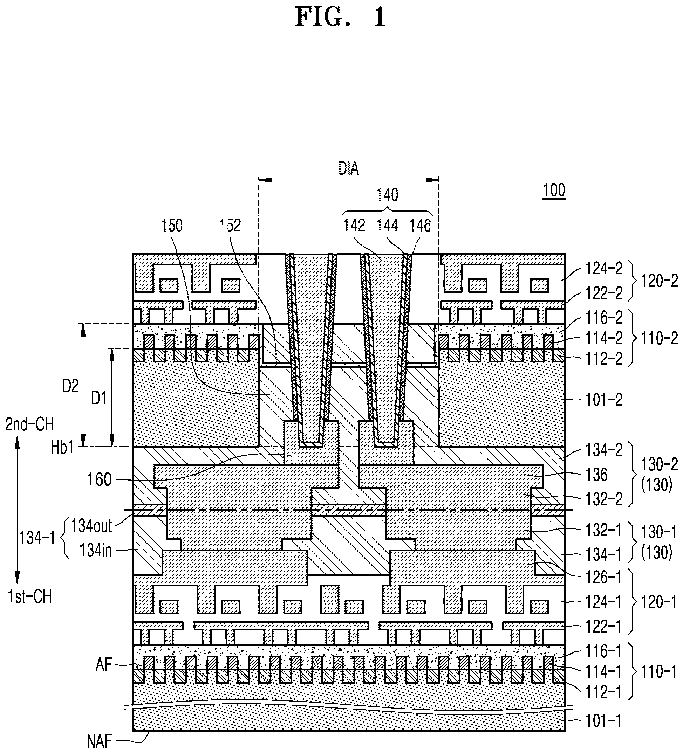

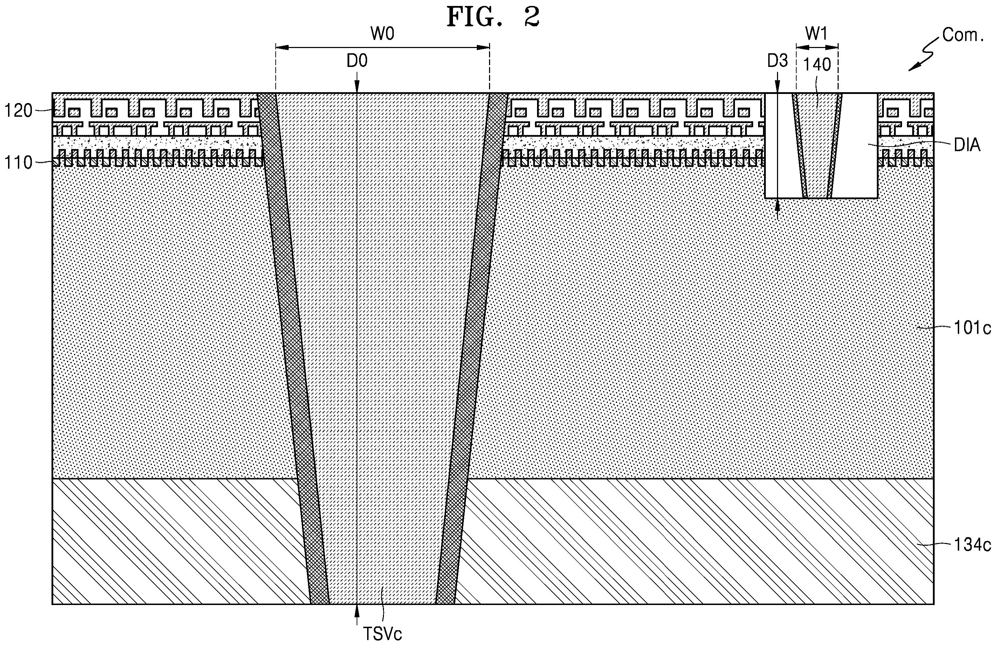

FIG. 1 is a cross-sectional view of a semiconductor device 100 according to embodiments and FIG. 2 is a conceptual diagram for comparing the size of a through-electrode of the semiconductor device of FIG. 1 with the size of a through-electrode of a semiconductor device of a comparative example.

Referring to FIGS. 1 and 2, the semiconductor device 100 of the current embodiment may include a first semiconductor chip 1st-CH and a second semiconductor chip 2nd-CH.

The first semiconductor chip 1st-CH may be arranged at the bottom, and the second semiconductor chip 2nd-CH may be arranged on the first semiconductor chip 1 st-CH.

The second semiconductor chip 2nd-CH may be stacked on the first semiconductor chip 1st-CH through hybrid copper bonding (HCB).

However, in some embodiments, the second semiconductor chip 2nd-CH may be stacked on the first semiconductor chip 1st-CH by using connection terminals such as bumps.

In the semiconductor device 100 of the current embodiment, the first semiconductor chip 1st-CH and the second semiconductor chip 2nd-CH may be the same type of semiconductor chips.

For example, the first semiconductor chip 1st-CH and the second semiconductor chip 2nd-CH may each be a logic chip including logic elements.

Specifically, the first semiconductor chip 1st-CH and the second semiconductor chip 2nd-CH may each be a logic chip including a field effect transistor (FET) device such as a finFET or a multi-bridge channel FET (MBCFET).

For reference, the logic elements may include an AND, a NAND, an OR, NOR, an exclusive OR (XOR), an exclusive NOR (XNOR), an inverter INV, an adder ADD, a buffer BUF, a delay DLY, a filter FIL, a multiplexer MXT/MXIT, an OR/AND/INVERTER (OAI), an AND/OR (AO), AND/OR/INVERTER (AOI), a D flip-flop, a reset flip-flop, a master-slave flip-flop, a latch, or counter elements.

The logic elements may perform various signal processing such as analog signal processing, analog-to-digital (A/D) conversion, and control.

A logic chip may be referred to as a central processing unit (CPU) chip, a microprocessor unit (MPU) chip, a graphics processing unit (GPU) chip, a neural processing unit (NPU) chip, a system on glass (SOG) chip, an application specific integrated circuit (ASIC) chip, an application processor (AP) chip, or a control chip according to a function thereof. In the semiconductor device 100 of the current embodiment, for example, the first semiconductor chip 1st-CH and the second semiconductor chip 2nd-CH may be memory chips including memory devices. For example, the first semiconductor chip 1st-CH and the second semiconductor chip 2nd-CH may each be a memory chip including a memory device such as dynamic random access memory (DRAM), flash memory, static random access memory (SRAM), electrically erasable programmable read-only memory (EEPROM), phase-change random access memory (PRAM), magnetoresistive random access memory (MRAM), ferroelectric random access memory (FeRAM), or resistive random access memory (RRAM). However, in some embodiments, the first semiconductor chip 1st-CH and the second semiconductor chip 2nd-CH may be different types of semiconductor chips.

For example, the first semiconductor chip 1st-CH may be a logic chip and the second semiconductor chip 2nd-CH may be a memory chip. Conversely, the first semiconductor chip 1st-CH may be a memory chip and the second semiconductor chip 2nd-CH may be a logic chip. However, whether the first semiconductor chip 1st-CH and the second semiconductor chip 2nd-CH are of the same type or different types, the second semiconductor chip 2nd-CH on the first semiconductor chip 1st-CH may include a through-electrode 140. In addition, in some embodiments, the first semiconductor chip 1st-CH may also include a through-electrode. Hereinafter, structures of the first semiconductor chip 1st-CH and the second semiconductor chip 2nd-CH are described in more detail. The first semiconductor chip 1st-CH may include a first semiconductor substrate 101-1, a first integrated device layer 110-1, a first wiring layer 120-1, and a lower HCB structure 130-1. The first semiconductor substrate 101-1 may include, for example, Si.

However, the first semiconductor substrate 101-1 is not limited to Si, and may include another semiconductor device such as germanium (Ge), or a compound semiconductor such as SiC, GaAs, InAs, or InP. The first semiconductor substrate 101-1 may have a silicon on insulator (SOI) structure.

For example, the first semiconductor substrate 101-1 may include a buried oxide layer (BOX) layer. The first semiconductor substrate 101-1 may include a conductive region, for example, a well doped with impurities, or a structure doped with impurities. The conductive region formed in an upper portion of the first semiconductor substrate 101-1 may constitute part of the first integrated device layer 110-1. For example, a first source/drain region 112-1 doped with impurities is formed in the upper portion of the first semiconductor substrate 101-1, and the first source/drain region 112-1 may constitute a transistor of the first integrated device layer 110-1. The first semiconductor substrate 101-1 may include various device isolation layers such as a shallow trench isolation (STI) structure. The device isolation layer of the first semiconductor substrate 101-1 may have substantially the same structure as a device isolation layer 150 of a second semiconductor substrate 101-2.

Accordingly, the device isolation layer of the first semiconductor substrate 101-1 may isolate the first integrated device layers 110-1 from each other.

The first semiconductor substrate 101-1 has an active surface AF and an opposite non-active surface NAF, and the first integrated device layer 110-1 and a first wiring layer 120-1 may be formed on the active surface AF. In the semiconductor device 100 of the current embodiment, a top surface of the first semiconductor substrate 101-1 may correspond to the active surface AF, and a bottom surface of the first semiconductor substrate 101-1 may correspond to the non-active surface NAF. In some embodiments, in the concept of a semiconductor chip, the active surface AF may refer to a surface on which a wiring layer or pad is formed. The first integrated device layer 110-1 may be arranged on the first semiconductor substrate 101-1.

The first integrated device layer 110-1 may include first source/drain regions 112-1, first gate lines 114-1, and a first insulating layer 116-1. The first source/drain regions 112-1 and the first gate lines 114-1 may form a transistor. In addition, a channel region may be arranged between the first source/drain regions 112-1 under the first gate lines 114-1.

In FIG. 1, the transistor is illustrated having a planar FET structure. However, the structure of the transistor is not limited thereto. For example, the transistor of the first integrated device layer 110-1 may have a finFET or MBCFET structure.

Meanwhile, in the semiconductor device 100 of the current embodiment, integrated devices formed in the first integrated device layer 110-1 are not limited to transistors. For example, various integrated devices related to logic elements and memory devices may be formed in the first integrated device layer 110-1. The first insulating layer 116-1 may cover the first gate lines 114-1 to electrically insulate adjacent first gate lines 114-1.

The first insulating layer 116-1 may correspond to the lowermost interlayer insulating layer. The first insulating layer 116-1 may include an oxide layer, a nitride layer, or an oxynitride layer. For example, in the semiconductor device 100 of the current embodiment, the first insulating layer 116-1 may include a nitride layer such as silicon nitride (SiNx). However, the material of the first insulating layer 116-1 is not limited thereto. The first wiring layer 120-1 may be formed on the first integrated device layer 110-1. The first wiring layer 120-1 may include first wirings 122-1, a first interlayer insulating layer 124-1, and an aluminum (Al) pad 126-1. The first wirings 122-1 may be arranged having a multi-layer structure in the first interlayer insulating layer 124-1, and the first wirings 122-1 of different layers may be connected to each other through vertical vias.

In addition, the first wirings 122-1 may be connected to the first source/drain regions 112-1 of the first integrated device layer 110-1 through vertical contacts. The first wirings 122-1 and the vertical vias or vertical contacts may include a metal such as aluminum (Al), copper (Cu), or tungsten (W). In some embodiments, the first wirings 122-1 and the vertical vias or vertical contacts may include a barrier layer and a wiring metal layer. The barrier layer may include, for example, a metal such as titanium (Ti), tantalum (Ta), Al, ruthenium (Ru), manganese (Mn), cobalt (Co), W, or metal nitride or metal oxide, or may include an alloy such as cobalt tungsten phosphide (CoWP), cobalt tungsten boron (CoWB), or cobalt tungsten boron phosphide (CoWBP). In addition, the wiring metal layer may include at least one metal selected from W, Al, Ti, Ta, Ru, Mn, and Cu. The first interlayer insulating layer 124-1 may have a multilayer structure according to the multilayer structure of the first wirings 122-1. However, in FIG. 1, for convenience, the first interlayer insulating layer 124-1 is illustrated as a singlelayer structure.

The first interlayer insulating layer 124-1 may include, for example, tetraethyl orthosilicate (TEOS). However, the material of the first interlayer insulating layer 124-1 is not limited to TEOS. For example, the first interlayer insulating layer 124-1 may be formed of silicon oxide such as phosphorous silicate glass (PSG), boro-phosphorous silicate glass (BPSG), undoped silicate glass (USG), or plasma enhanced-TEOS (PE-TEOS) by high density plasmachemical vapor deposition (HDP-CVD). The Al pad 126-1 may be arranged in the uppermost portion of the first wiring layer 120-1.

The Al pad 126-1 may be connected to the first wirings 122-1. The Al pad 126-1 may include Al and may have a pad shape. In some embodiments, the Al pad 126-1 may be treated as another component distinct from the first wiring layer 120-1. The lower HCB structure 130-1 may be formed on the first wiring layer 120-1.

In some embodiments, the lower HCB structure 130-1 may be included in the first wiring layer 120-1. The lower HCB structure 130-1 may include a first pad 132-1 and a first protective layer 134-1. The first pad 132-1 may be arranged through an upper portion of the first protective layer 134-1. A top surface of the first pad 132-1 may be exposed from the first protective layer 134-1. The first pad 132-1 may include, for example, Cu, and thus may be referred to as a Cu pad.

However, the material of the first pad 132-1 is not limited to Cu. In some embodiments, the first pad 132-1 may include a barrier layer and a Cu layer. The barrier layer may include, for example, a metal such as Ti, Ta, Al, Ru, Mn, Co, or W, or metal nitride or metal oxide. The first pad 132-1 may be connected to the first wirings 122-1 of the first wiring layer 120 through the Al pad 126-1.

The first protective layer 134-1 may include an internal first protective layer 134in and an external first protective layer 134out. The internal first protective layer 134in may include, for example, a silicon oxide layer or a silicon nitride layer. The external first protective layer 134out may include, for example, a silicon oxide layer or a silicon carbon nitride layer.

However, the materials of the internal first protective layer 134in and the external first protective layer 134out are not limited to the materials described above. In some embodiments, the first protective layer 134-1 may have a structure of three or more layers. The top surface of the first pad 132-1 may be exposed from the external first protective layer 134out. In addition, the top surface of the first pad 132-1 may be substantially coplanar with a top surface of the external first protective layer 134out. However, as illustrated in FIG. 1, as the first pad 132-1 is combined with a second pad 132-2 and the external first protective layer 134out is combined with an external second protective layer, the top surface of the first pad 132-1 and the top surface of the external first protective layer 134out may not be clearly distinguished. The second semiconductor chip 2nd-CH may include a second semiconductor substrate 101-2, a second integrated device layer 110-2, a second wiring layer 120-2, an upper HCB structure 130-2, a through-electrode 140, a device isolation layer 150, and a contact metal layer 160. The second semiconductor substrate 101-2, the second integrated device layer 110-2, and the second wiring layer 120-2 are the same as those described for the first semiconductor substrate 101-1, the first integrated device layer 110-1, and the first wiring layer 120-1 of the first semiconductor chip 1st-CH.

For reference, a top surface of the second semiconductor substrate 101-2 may correspond to the active surface AF and a bottom surface of the second semiconductor substrate 101-2 may correspond to the non-active surface NAF. Accordingly, although not shown in FIG. 1, an Al pad and an upper pad may be arranged on the second wiring layer 120-2. In addition, another semiconductor chip such as a memory chip or a structure such as a redistribution substrate may be stacked on the second semiconductor chip 2nd-CH. Meanwhile, in the semiconductor device 100 of the current embodiment, the second semiconductor substrate 101-2 may have a small thickness. For example, the bottom surface of the second semiconductor substrate 101-2 may have a first bottom surface level Hb1 that is substantially the same as a bottom surface of the device isolation layer 150.

Accordingly, a first thickness D1 of the second semiconductor substrate 101-2 may be less than a second thickness D2 of the device isolation layer 150. Here, the second thickness D2 of the device isolation layer 150 may be defined as from a top surface of the second protective layer 134-2 to a bottom surface of the second wiring layer 120-2. The upper HCB structure 130-2 may be arranged under the second semiconductor substrate 101-2.

The upper HCB structure 130-2 may include a second pad 132-2, a second protective layer 134-2, and a pad redistribution layer 136.

The lower HCB structure 130-1 and the upper HCB structure 130-2 may constitute the HCB structure 130. The second pad 132-2 may be arranged through a lower portion of the second protective layer 134-2. A bottom surface of the second pad 132-2 may be exposed from the second protective layer 134-2. The structure and material of the second pad 132-2 are the same as those described above for the first pad 132-1.

Meanwhile, the second pad 132-2 may be connected to the pad redistribution layer 136. For reference, when the upper pad is arranged on a top surface of the second semiconductor chip 2nd-CH, the second pad 132-2 may correspond to a lower pad of the second semiconductor chip 2nd-CH. The second protective layer 134-2 may include an internal second protective layer and an external second protective layer. The structure and material of the second protective layer 134-2 are the same as those described for the first protective layer 134-1.

The bottom surface of the second pad 132-2 may be exposed from the external second protective layer. The pad redistribution layer 136 may be arranged in the second protective layer 134-2. The pad redistribution layer 136 may correspond to a redistribution line connecting the through-electrode 140 to the second pad 132-2.

The pad redistribution layer 136 may have a single or multilayer structure. When the pad redistribution layer 136 has a multilayer structure, redistribution lines of different layers may be connected to each other by vertical vias. The pad redistribution layer 136 may include a barrier layer on an external surface thereof. The barrier layer is the same as described in the description of the first wirings 122-1. The through-electrode 140 passing through at least part of the device isolation layer 150 and the second wiring layer 120-2 may be arranged in a device isolation layer region DIA.

Here, the device isolation layer region DIA may include parts of the device isolation layer 150 and the second interlayer insulating layer 124-2 corresponding thereto. In the semiconductor device 100 of the current embodiment, the through-electrode 140 may be arranged only in the device isolation layer region DIA and may not be arranged in other regions. The through-electrode 140 may have a three-dimensional columnar shape.

For example, the through-electrode 140 may have a three-dimensional cylindrical shape. In addition, as noted from FIG. 1, the through-electrode 140 may have a shape with a wide upper portion and a narrow lower portion. However, in some embodiments, the through-electrode 140 may have a shape in which widths of the upper and lower portions are substantially the same. The through-electrode 140 may include an electrode metal 142, a barrier metal 144, and an insulating liner 146. The electrode metal 142 may correspond to a buried conductive layer arranged at the internal center of the through-electrode 140. The electrode metal 142 may include, for example, at least one material selected from Cu alloys such as Cu, CuSn, CuMg, CuNi, CuZn, CuPd, CuAu, CuRe, and CuW, W, W alloys, nickel (Ni), Ru, and Co.

The barrier metal 144 may surround an outer surface of the electrode metal 142, for example, bottom and side surfaces of the electrode metal 142. The barrier metal 144 may include at least one material selected from, for example, Ti, TiN, Ta, TaN, Ru, Co, Mn, WN, Ni, and NiB. In the semiconductor device 100 of the current embodiment, the electrode metal 142 may include Cu, and the barrier metal 144 may include Ta/TaN.

However, the materials of the electrode metal 142 and the barrier metal 144 are not limited to the materials described above. The insulating liner 146 may have a structure surrounding a side surface of the barrier metal 144. Specifically, the insulating liner 146 may be arranged between the barrier metal 144 and the device isolation layer 150 and between the barrier metal 144 and the second wiring layer 120-2. The insulating liner 146 may include, for example, an oxide layer, a nitride layer, a carbonization layer, a polymer layer, or a combination thereof.

In some embodiments, the insulating liner 146 may be omitted. The device isolation layer 150 may be arranged on the second protective layer 134-2. The device isolation layer 150 may isolate the second integrated device layer 110-2. The device isolation layer 150 may include, for example, an oxide layer, a nitride layer, or an oxynitride layer. As noted from FIG. 1, the device isolation layer 150 may include a boundary layer 152 including a different material in the middle portion thereof. For example, the device isolation layer 150 may include a silicon oxide layer and the boundary layer 152 of a silicon nitride layer in the middle portion thereof. The boundary layer 152 may be formed in a process of forming a gate line by using a replacement metal gate (RMG) process.

In addition, the boundary layer 152 may be connected to a second insulating layer 116-2 thereon, although in some embodiments, the boundary layer 152 may not be connected to the second insulating layer 116-2. For example, the bottom surface of the device isolation layer 150 may have the first bottom surface level Hb1 that is substantially the same as a level of the bottom surface of the second semiconductor substrate 101-2, which may be because, as will be described later in the description of a method of manufacturing a semiconductor device, in a process of removing a lower portion of the second semiconductor substrate 101-2, the lower portion of the second semiconductor substrate 101-2 is removed by using the device isolation layer 150 as an etching stop layer. As described above, the through-electrode 140 may be arranged only in a region in which the device isolation layer 150 is arranged, that is, in the device isolation layer region DIA.

In addition, a bottom surface of the through-electrode 140 may be maintained above the first bottom surface level Hb1 that is the level of the bottom surface of the device isolation layer 150. In FIG. 1, the bottom surface of the through-electrode 140 may have the first bottom surface level Hb1 that is substantially the same as the bottom surface of the device isolation layer 150. By arranging the through-electrode 140 only in the device isolation layer region DIA and maintaining the bottom surface of the through-electrode 140 above the first bottom surface level Hb1 that is the level of the bottom surface of the device isolation layer 150, the size of the through-electrode 140 may be significantly reduced. In FIG. 2, a semiconductor device Com. of a comparative example is illustrated, and for size comparison, the device isolation layer region DIA and the through-electrode 140 of the semiconductor device 100 of the current embodiment are illustrated together. As noted from FIG. 2, in the semiconductor device Com. of the comparative example, a thickness of a semiconductor substrate 101c may be greater than a thickness of the device isolation layer.

For example, a level of a bottom surface of the semiconductor substrate 101c may be lower than the level of the bottom surface of the device isolation layer, and the semiconductor substrate 101c may be maintained under the device isolation layer.

In the semiconductor device Com. of the comparative example, a through-electrode TSVc may pass through the semiconductor substrate 101c and a protective layer 134c. Because the through-electrode TSVc passes through the thick semiconductor substrate 101c, the through-electrode TSVc may have a large size. For example, the through-electrode TSVc may have a base thickness D0 and a base width WO. On the other hand, in the semiconductor device 100 of the current embodiment, because the through-electrode 140 passes through only the device isolation layer region DIA, the through-electrode 140 may have a very small size.

For example, the through-electrode 140 may have a third thickness D3 and a first width W1. Here, the thickness refers to a thickness of the metal layer in which the electrode metal is combined with the barrier metal, and in FIG. 2, it is illustrated as one metal layer without distinction between the electrode metal and the barrier metal. The width is defined as a diameter of a top surface of the metal layer when the through-electrode TSVc or 140 is cylindrical, is defined as a width of a long axis of the top surface of the metal layer when the through-electrode TSVc or 140 is in the form of an elliptical pillar, and is defined as a width of the widest portion of the top surface of the metal layer when the through-electrode TSVc or 140 is in the form of a polygonal pillar. Meanwhile, resistance of the through-electrode TSVc or 140 may be determined by the width and length (that is, thickness) of the metal layer. Accordingly, when the through-electrode TSVc or 140 has the same resistance, when the base thickness D0 of the through-electrode TSVc is 10 µm and the base width WO is 1 µm, when the third thickness D3 of the through-electrode 140 is reduced to about 2 µm, the first width W1 may also be reduced to about 0.2 µm.

Accordingly, compared to the semiconductor device Com. of the comparative example, in the semiconductor device 100 of the current embodiment, the thickness of the second semiconductor chip 2nd-CH may be significantly reduced so that the thickness or height of the entire semiconductor device 100 may also be significantly reduced. In addition, based on reduction in the size of the through-electrode 140, density of the through-electrode 140 may be increased so that density of I/O connected to the through-electrode 140 may also be increased. Meanwhile, in FIG. 2, an insulating liner may be arranged outside the metal layer. The insulating liner may be arranged to insulate the metal layer of the through-electrode TSVc from the semiconductor substrate 101c. However, in the semiconductor device 100 of the current embodiment, the through-electrode 140 may be arranged only in the device isolation layer region DIA. Accordingly, in the semiconductor device 100 of the current embodiment, the insulating liner 146 of the through-electrode 140 may be omitted. When a thickness of the insulating liner 146 is about 5% of the total width or total diameter of the through-electrode 140, the insulating liner 146 may occupy about 20% of the total volume of the through-electrode 140.

Accordingly, in the semiconductor device 100 of the current embodiment, the volume of the through-electrode 140 may be reduced by omitting the insulating liner 146. For reference, in the semiconductor device Com. of the comparative example, the through-electrode TSVc may pass through Si of the semiconductor substrate 101c. Accordingly, the through-electrode TSVc may be referred to as a through silicon via (TSV). On the other hand, in the semiconductor device 100 of the current embodiment, because the through-electrode 140 does not pass through the second semiconductor substrate 101-2, strictly speaking, the through-electrode 140 may not correspond to the TSV.

However, the through-electrode 140 does not directly pass through the second semiconductor substrate 101-2, and the through-electrode 140 may be illustrated as passing through the second semiconductor substrate 101-2 through an insulating layer. Accordingly, the through-electrode 140 may still be referred to as the TSV. The contact metal layer 160 may be arranged between the through-electrode 140 and the pad redistribution layer 136. The contact metal layer 160 may electrically connect the through-electrode 140 to the pad redistribution layer 136. As illustrated in FIG. 1, the contact metal layer 160 may surround the bottom surface of the through-electrode 140 and the side surface of the through-electrode 140 adjacent to the bottom surface of the through-electrode 140. Based on the structure, the contact metal layer 160 may be referred to as an around metal.

However, the structure of the contact metal layer 160 is not limited to the structure of the around metal. The contact metal layer 160 may include a barrier layer on an external surface thereof. The barrier layer is the same as described in the description of the first wirings 122-1. When the through-electrode 140 includes the insulating liner 146, the insulating liner 146 may not be formed in a portion in which the through-electrode 140 is connected to the contact metal layer 160. In other words, the barrier metal 144 of the through-electrode 140 may be connected to the contact metal layer 160. In the semiconductor device 100 of the current embodiment, the first semiconductor chip 1st-CH may be combined with the second semiconductor chip 2nd-CH through HCB.

HCB may refer to bonding that is a combination of pad-to-pad bonding and insulator-to-insulator bonding. Meanwhile, as the pad usually includes Cu, in HCB, C may mean copper. In the semiconductor device 100 of the current embodiment, the first pad 132-1 is combined with the second pad 132-2, and the first protective layer 134-1 is combined with the second protective layer 134-2 to form HCB. For reference, to explain HCB in more detail, plasma treatment and ultrapure water cleaning may be performed on a lower wafer including the first semiconductor chip 1st-CH and an upper wafer including the second semiconductor chip 2nd-CH before bonding to form an OH dangling bond on the first protective layer 134-1 and the second protective layer 134-2. Thereafter, the upper wafer is bonded to the lower wafer so that the second pad 132-2 is aligned with the first pad 132-1 at room temperature. At the beginning of bonding, OH dangling bonds of the first protective layer 134-1 of the lower wafer and the second protective layer 134-2 of the upper wafer may form hydrogen bonding. Hydrogen bonding may have relatively low bonding strength.

Thereafter, heat is applied through annealing, and a tight bonding structure may be formed between the first pad 132-1 and the second pad 132-2. Specifically, a metal expansion process and a metal diffusion process may occur in the first pad 132-1 and the second pad 132-2 through annealing, and the first pad 132-1 and the second pad 132-2 may be integrated through the metal expansion and diffusion processes.

Meanwhile, through annealing, hydrogen bonding between the first protective layer 134-1 and the second protective layer 134-2 changes to oxide bonding. For example, simply expressed by a chemical formula, the chemical formula -OH + -OH --> O + H₂O is established through high-temperature annealing. Oxide bonding may have higher bonding strength than hydrogen bonding. As a result, the first semiconductor chips 1st-CH of the lower wafer may be firmly combined with the second semiconductor chips 2nd-CH of the upper wafer.

In the semiconductor device 100 of the current embodiment, the combination of the first semiconductor chip 1st-CH and the second semiconductor chip 2nd-CH is not limited to combination through HCB. For example, the first semiconductor chip 1st-CH may be combined with the second semiconductor chip 2nd-CH through connection terminals such as bumps. The semiconductor device 100 of the current embodiment has a structure in which the second semiconductor chip 2nd-CH is stacked on the first semiconductor chip 1st-CH, and the second semiconductor chip 2nd-CH may include the through-electrode 140. In addition, the through-electrode 140 is arranged only in the device isolation layer region DIA, and the bottom surface level of the through-electrode 140 may be higher than or the same as the bottom surface level of the device isolation layer 150.

Furthermore, the level of the bottom surface of the second semiconductor substrate 101-2 of the second semiconductor chip 2nd-CH may be substantially the same as the level of the bottom surface of the device isolation layer 150. Accordingly, in the semiconductor device 100 of the current embodiment, the through-electrode 140 may have a very small size, and the thickness of the second semiconductor chip 2nd-CH may be significantly reduced. In addition, the thickness or height of the entire semiconductor device 100 may be significantly reduced. Furthermore, based on the reduction in the size of the through-electrode 140, the density of the through-electrode 140 may be increased so that the density of the I/O connected to the through-electrode 140 may also be increased. Meanwhile, in the semiconductor device 100 of the current embodiment, the volume of the through-electrode 140 may be reduced by omitting the insulating liner 146. When a plurality of through-electrodes 140 are arranged in the device isolation layer region DIA, and at least one of the plurality of through-electrodes 140 is formed shorter than a target, difficulties may arise in removing heterogeneous films together.

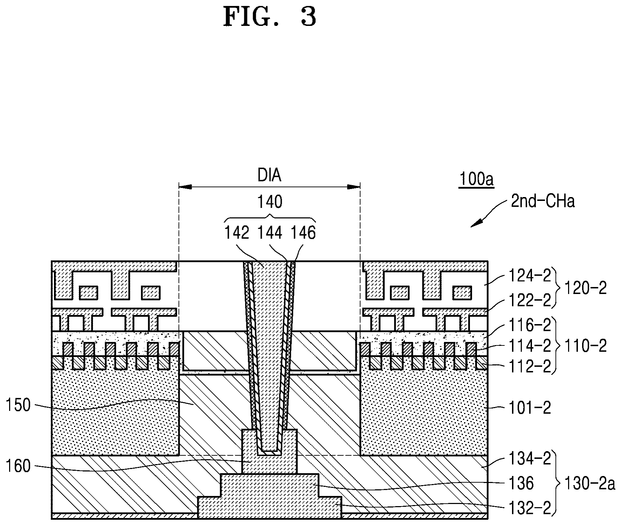

However, in the case of the semiconductor device 100 of the current embodiment, the above-described problem may be solved by employing the contact metal layer 160. FIG. 3 is a cross-sectional view of a semiconductor device 100a according to embodiments, in which only a second semiconductor chip is illustrated and a first semiconductor chip is omitted.

The descriptions previously given with reference to FIGS. 1 and 2 are briefly given or omitted. Referring to FIG. 3, the semiconductor device 100a of the current embodiment may be different from the semiconductor device 100 of FIG. 1 in that one through-electrode 140 is arranged in the device isolation layer region DIA. Specifically, in the semiconductor device 100 of FIG. 1, a plurality of, for example, two through-electrodes 140 may be arranged in one device isolation layer region DIA.

In contrast, in the semiconductor device 100a of the current embodiment, one through-electrode 140 may be arranged in one device isolation layer region DIA. A first semiconductor chip 1st-CH, and second semiconductor substrate 101-2, a second integrated device layer 110-2, and a second wiring layer 120-2 of a second semiconductor chip 2nd-CHa excluding a lower HCB structure are the same as in the description of the semiconductor device 100 in FIG. 1. The lower HCB structure and an upper HCB structure 130-2a correspond to one through-electrode 140 and may be different from the structure in the semiconductor device 100 of FIG. 1. That is, one through-electrode 140 may be connected to one second pad 132-2 through a contact metal layer 160 and a pad redistribution layer 136, and may also be connected to one first pad 132-1 through HCB of the first semiconductor chip 1st-CH and the second semiconductor chip 2nd-CHa.

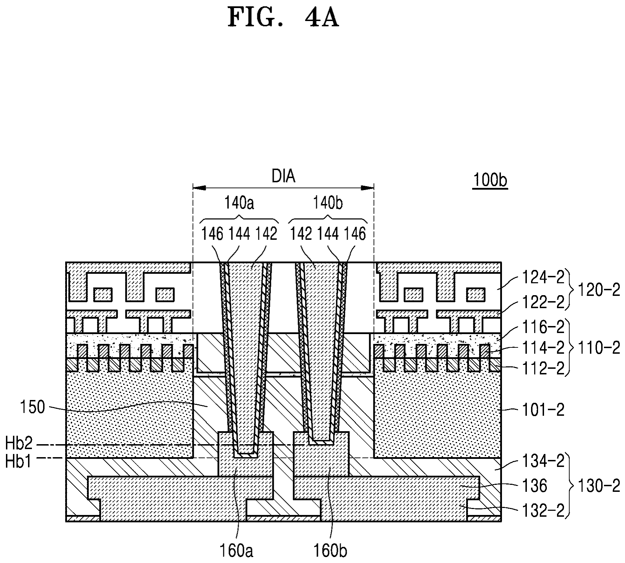

FIGS. 4A to 4D are cross-sectional views of semiconductor devices 100b, 100c, 100d, and 100e according to embodiments, in which only a second semiconductor chip is illustrated and a first semiconductor chip is omitted. The descriptions previously given with reference to FIGS. 1 to 3 are briefly given or omitted.

Referring to FIG. 4A, the semiconductor device 100b of the current embodiment may be different from the semiconductor device 100 of FIG. 1 in that levels of bottom surfaces of the first and second through-electrodes 140a and 140b are different from each other. Specifically, in the semiconductor device 100 of FIG. 1, two through-electrodes 140 may be arranged in one device isolation layer region DIA and levels of bottom surfaces of two through-electrodes 140 may be substantially the same.

For example, the levels of the bottom surfaces of the two through-electrodes 140 may be substantially the same as the first bottom surface level Hb1 of a bottom surface of a device isolation layer 150 or a second semiconductor substrate 101-2, which is a target level. In contrast, in the semiconductor device 100b of the current embodiment, the first and second through-electrodes 140a and 140b may be arranged in one device isolation layer region DIA, the bottom surface of the first through-electrode 140a may be at the target level, and the bottom surface of the second through electrode 140b may be at a higher level than the target level. That the level of the bottom surface of the second through-electrode 140b is higher than the target level may mean that a length of the second through-electrode 140b is less than the target length. Specifically, the bottom surface of the first through-electrode 140a may be substantially the same as the first bottom surface level Hb1 of the bottom surface of the device isolation layer 150 or the second semiconductor substrate 101-2, which is the target level. However, the bottom surface of the second through-electrode 140b may have a second bottom surface level Hb2 that is higher than the first bottom surface level Hb1 of the bottom surface of the device isolation layer 150 or the second semiconductor substrate 101-2. In this way, when the first and second through-electrodes 140a and 140b are formed in the device isolation layer region DIA, and the second through-electrode 140b of the first and second through-electrodes 140a and 140b is formed shorter than the target length, in other words, the second bottom surface level Hb2 of the bottom surface of the second through-electrode 140b is higher than the first bottom surface level Hb1, which is the target level, in order to expose the bottom surface of the second through-electrode 140b, an insulating layer of the device isolation layer 150 and an Si layer of the second semiconductor substrate 101-2 must be removed together.

In this way, the process of removing heterogeneous films together may be difficult, and additional processes may be required. However, in the case of the semiconductor device 100b of the current embodiment, first and second contact metal layers 160a and 160b are arranged between the first and second through-electrodes 140a and 140b and a pad redistribution layer 136 so that there is no need to perform the process of removing the heterogeneous films together.

In other words, by forming the first and second contact metal layers 160a and 160b connected to the first and second through-electrodes 140a and 140b in the device isolation layer 150, there is no need to perform the process of removing the heterogeneous films together. Specifically, the first contact metal layer 160a may correspond to the first through-electrode 140a and the second contact metal layer 160b may correspond to the second through-electrode 140b. As the second bottom surface level Hb2 of the bottom surface of the second through-electrode 140b is higher than the first bottom surface level Hb1 of the bottom surface of the first through-electrode 140a, a depth at which the second through-electrode 140b is inserted into the second contact metal layer 160b is less than a depth at which the first through-electrode 140a is inserted into the first contact metal layer 160a.

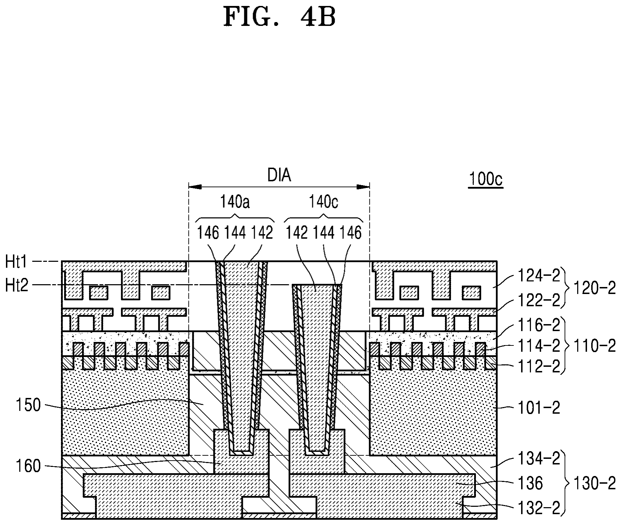

In other words, by forming the contact metal layer 160 with a sufficient thickness in the device isolation layer 150 and controlling the depth at which the through-electrodes 140a and 140b are inserted, the problem of having to remove the heterogeneous films together to expose the bottom surface of the through-electrode of which length is less than the target length may be solved. So far, the structure in which the first and second through-electrodes 140a and 140b are arranged in the device isolation layer region DIA has been described. However, the structure in which the first and second through-electrodes 140a and 140b are arranged is not limited thereto. For example, even in a structure in which three or more through-electrodes are arranged in the device isolation layer region DIA, the problem of having to remove the heterogeneous films together may be solved by forming the contact metal layer 160. Referring to FIG. 4B, the semiconductor device 100c of the current embodiment may be different from the semiconductor device 100 of FIG. 1 in that levels of top surfaces of first and second through-electrodes 140a and 140c are different from each other.

Specifically, in the semiconductor device 100 of FIG. 1, two through-electrodes 140 may be arranged in one device isolation layer region DIA, and the levels of the top surfaces of the two through-electrodes 140 may be substantially the same. In contrast, in the semiconductor device 100c of the current embodiment, the first and second through-electrodes 140a and 140c are arranged in one device isolation layer region DIA, and the top surface of the first through-electrode 140a may have a first top surface level Ht1, and the top surface of the second through-electrode 140c may have a second top surface level Ht2.

The first top surface level Ht1 may be higher than the second top surface level Ht2. In this way, the first and second through-electrodes 140a and 140c with different top surface levels may be formed through different processes. For example, the second through-electrode 140c may be formed first, and then second wirings 122-2 at a level higher than the top surface of the second through-electrode 140c may be formed. Thereafter, the first through-electrode 140a may be formed. So far, the structure in which the first and second through-electrodes 140a and 140c are arranged in the device isolation layer region DIA has been described. However, the structure in which the first and second through-electrodes 140a and 140c are arranged is not limited thereto.

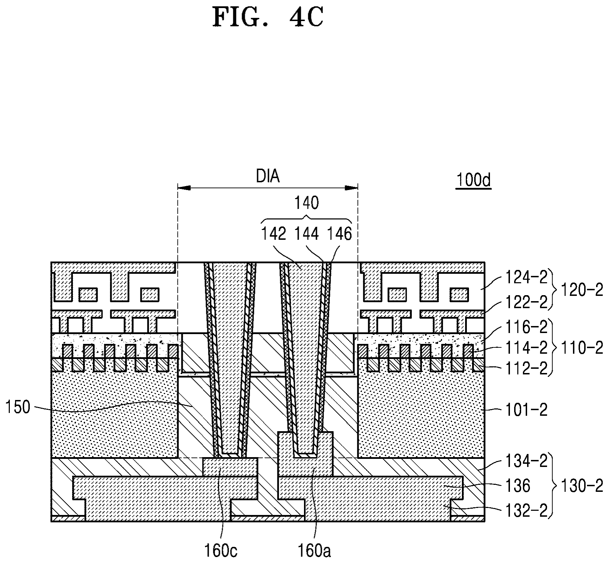

For example, three or more through-electrodes may be arranged in the device isolation layer region DIA, and at least one of the three or more through-electrodes may have a top surface lower than the other through-electrodes. Referring to FIG. 4C, the semiconductor device 100d of the current embodiment may be different from the semiconductor device 100 of FIG. 1 in that shapes of first and second contact metal layers 160a and 160c are different from each other.

Specifically, in the semiconductor device 100 of FIG. 1, two contact metal layers 160 may have the same around metal structure. In contrast, in the semiconductor device 100d of the current embodiment, the first contact metal layer 160a may have an around metal structure, and the second contact metal layer 160c may have a pad metal structure.

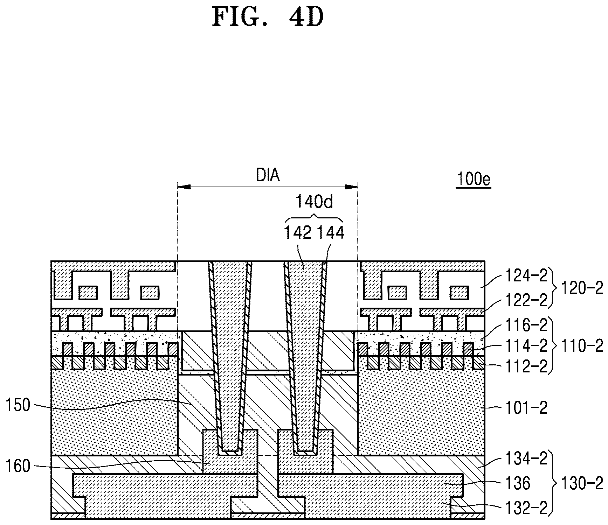

The first and second contact metal layers 160a and 160c having different shapes may be formed through different processes. For example, a photo process may be performed on a portion of the device isolation layer 150 corresponding to the right through-electrode 140 to form a first contact metal layer 160a, and then a photo process may be performed on a portion of the device isolation layer 150 corresponding to the left through-electrode 140 to form a second contact metal layer 160c. Referring to FIG. 4D, the semiconductor device 100e of the current embodiment may be different from the semiconductor device 100 of FIG. 1 in a structure of a through-electrode 140d. Specifically, in the semiconductor device 100 of FIG. 1, the through-electrode 140 may include the electrode metal 142, the barrier metal 144, and the insulating liner 146. That is, a side surface of the through-electrode 140 may have a triple-layer structure.

In contrast, in the semiconductor device 100e of the current embodiment, the through-electrode 140d may include an electrode metal 142 and a barrier metal 144. That is, the through-electrode 140d may not include an insulating liner, and a side surface of the through-electrode 140d may have a double-layer structure.

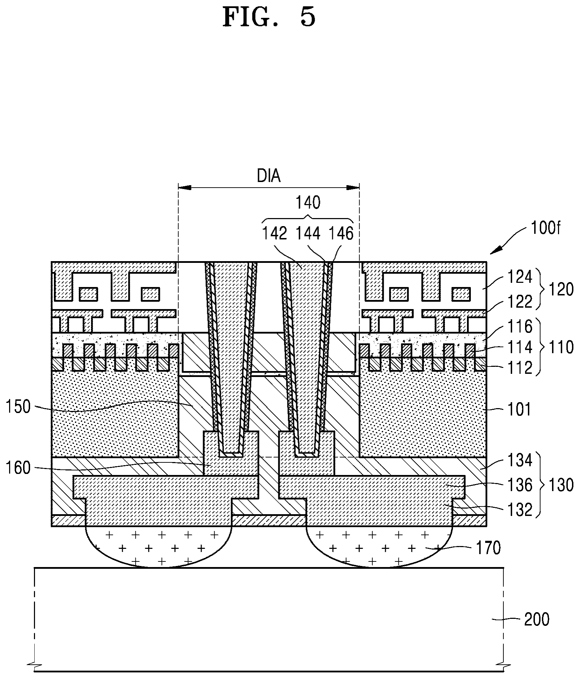

As described above, in the semiconductor device 100e of the current embodiment, the through-electrode 140d may be formed only in a device isolation layer region DIA. Accordingly, the problem of the metal material of the electrode metal 142 or the barrier metal 144 of the through-electrode 140d being in contact with Si of the second semiconductor substrate 101-2 may not occur. Accordingly, the through-electrode 140d may not include an insulating liner. In addition, because the through-electrode 140d does not include the insulating liner, the size of the through-electrode 140d may be reduced compared to the through-electrode 140 including the insulating liner 146. FIG. 5 is a cross-sectional view of a semiconductor device 100f according to embodiments.

The descriptions previously given with reference to FIGS. 1 to 4D are briefly given or omitted. Referring to FIG. 5, the semiconductor device 100f of the current embodiment may include one semiconductor chip. For example, the semiconductor device 100f of the current embodiment may include the second semiconductor chip 2nd-CH of the semiconductor device 100 of FIG. 1. The second semiconductor chip 2nd-CH is the same as in the description of the semiconductor device 100 of FIG. 1. However, because the first semiconductor chip does not exist, '-2' is deleted from the reference numerals in FIG. 5.

The semiconductor device 100f of the current embodiment may include connection terminals 170 arranged on bottom surfaces of pads 132. The connection terminals 170 may include, for example, solders. The solder may include tin (Sn), indium (In), bismuth (Bi), antimony (Sb), Cu, silver (Ag), zinc (Zn), and/or an alloy thereof. The solders may be referred to as bumps or solder bumps.

In some embodiments, the connection terminals 170 may include pillars, and the solders may be arranged on the pillars. The pillar may include, for example, Ni, Cu, palladium (Pd), platinum (Pt), gold (Au), or a combination thereof.

The semiconductor device 100f of the current embodiment may be mounted on a base substrate 200 through the connection terminals 170. The base substrate 200 may include, for example, an interposer. The interposer may mediate signal transmission between semiconductor devices mounted thereon. In addition, the interposer may mediate transmission of a signal and power between semiconductor devices and a package substrate.

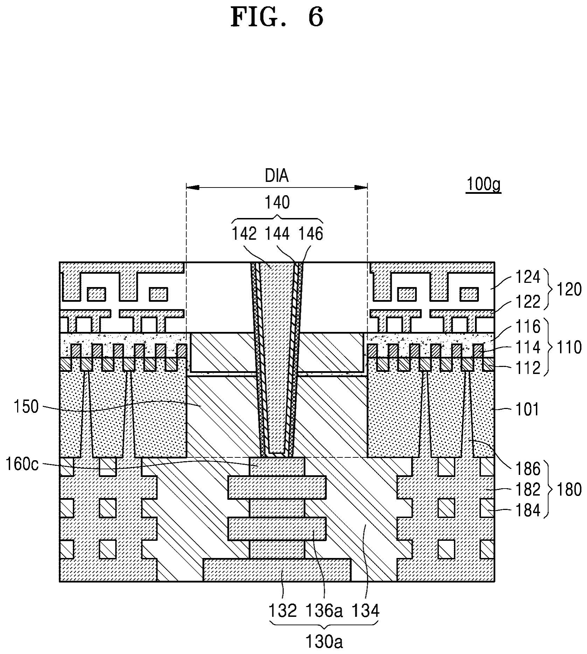

For example, the interposer may be mounted on a package substrate and may connect semiconductor devices to the package substrate. In some embodiments, the base substrate 200 may include a package substrate. In addition, in some embodiments, the base substrate 200 may include a semiconductor chip. The semiconductor device 100f of the current embodiment may include only one semiconductor chip. The semiconductor device 100f of the current embodiment may be stacked on various structures such as an interposer or a package substrate through the connection terminals 170 arranged thereunder. FIG. 6 is a cross-sectional view of a semiconductor device 100g according to embodiments.

The descriptions previously given with reference to FIGS. 1 to 5 are briefly given or omitted. Referring to FIG. 6, the semiconductor device 100g of the current embodiment may include one semiconductor chip. For example, the semiconductor device 100g of the current embodiment may include a semiconductor chip that is similar to the second semiconductor chip 2nd-CHa of the semiconductor device 100a of FIG. 3. However, the semiconductor device 100g of the current embodiment may be different from the second semiconductor chip 2nd-CHa of the semiconductor device 100a of FIG. 3 in that a back-side power delivery network (BSPDN) layer 180 is further arranged under the semiconductor substrate 101. For reference, a BSPDN may literally mean a structure in which a PDN is arranged on the back of a substrate. A network may be divided into a signal network and a power transmission network according to a purpose thereof. A signal network may refer to a set of wirings used to transmit and receive signals between transistors or to and from the outside.

On the other hand, a power delivery network may mean a set of wirings supplying power to operate a transistor. The BSPDN layer 180 may include power wirings 182, an insulating layer 184, and vertical contacts 186.

The power wirings 182 of different layers may be connected to each other through vertical vias. The vertical contacts 186 may pass through a semiconductor substrate 101, and the power wirings 182 may be connected to a source/drain region 112 through the vertical contacts 186.

Meanwhile, the lowermost portions of the power wirings 182 may form pads. In the semiconductor device 100g of the current embodiment, a pad redistribution layer 136a of an HCB structure 130a may have a multilayer structure. A pad 132 may be arranged under the pad redistribution layer 136a. A contact metal layer 160c may be arranged between a through-electrode 140 and the HCB structure 130a. The contact metal layer 160c may have a pad metal structure. However, the inventive concept is not limited thereto, and the contact metal layer 160c may have an around metal structure. In the semiconductor device 100g of the current embodiment, a connection terminal such as a bump may be arranged on the pad of the BSPDN layer 180 and the pad 132 of the HCB structure 130a.

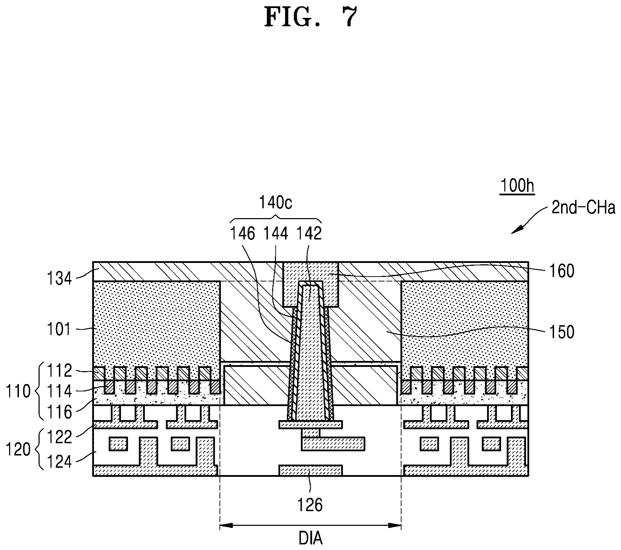

The semiconductor device 100g may be mounted on an interposer, a package substrate, or another semiconductor chip through the connection terminal. In some embodiments, the semiconductor device 100g of the current embodiment may be combined with another semiconductor chip through HCB. In such a case, the connection terminal may not be arranged on the pad of the BSPDN layer 180 and the pad 132 of the HCB structure 130a. FIG. 7 is a cross-sectional view of a semiconductor device 100h according to embodiments.

The descriptions previously given with reference to FIGS. 1 to 6 are briefly given or omitted. The semiconductor device 100h of the current embodiment may include one semiconductor chip. For example, the semiconductor device 100h of the current embodiment may include a semiconductor chip that is similar to the second semiconductor chip 2nd-CHa of the semiconductor device 100a of FIG. 3. However, the semiconductor device 100h of the current embodiment may be different from the semiconductor device 100a of FIG. 3 in that a second semiconductor chip 2nd-CH has a flipped structure and an HCB structure is not arranged on a contact metal layer 160. For reference, compared to the semiconductor device 100a of FIG. 3, top surfaces of a through-electrode 140c, a device isolation layer 150, and a semiconductor substrate 101 may correspond to bottom surfaces of the through-electrode 140, the device isolation layer 150, and the second semiconductor substrate 101-2 of the second semiconductor chip 2nd-CHa.

A bottom surface of the semiconductor device 100h of the current embodiment may include an active surface and a top surface of the semiconductor device 100h may include a non-active surface. In addition, the through-electrode 140c may not completely pass through a wiring layer 120 but may only partially pass through the wiring layer 120. In addition, the through-electrode 140c may be connected to wirings 122 of the wiring layer 120. The wirings 122 may be connected to lower pads 126.

Meanwhile, the contact metal layer 160 may serve as an upper pad. In the semiconductor device 100h of the current embodiment, connection terminals such as bumps may be arranged on the lower pads 126.

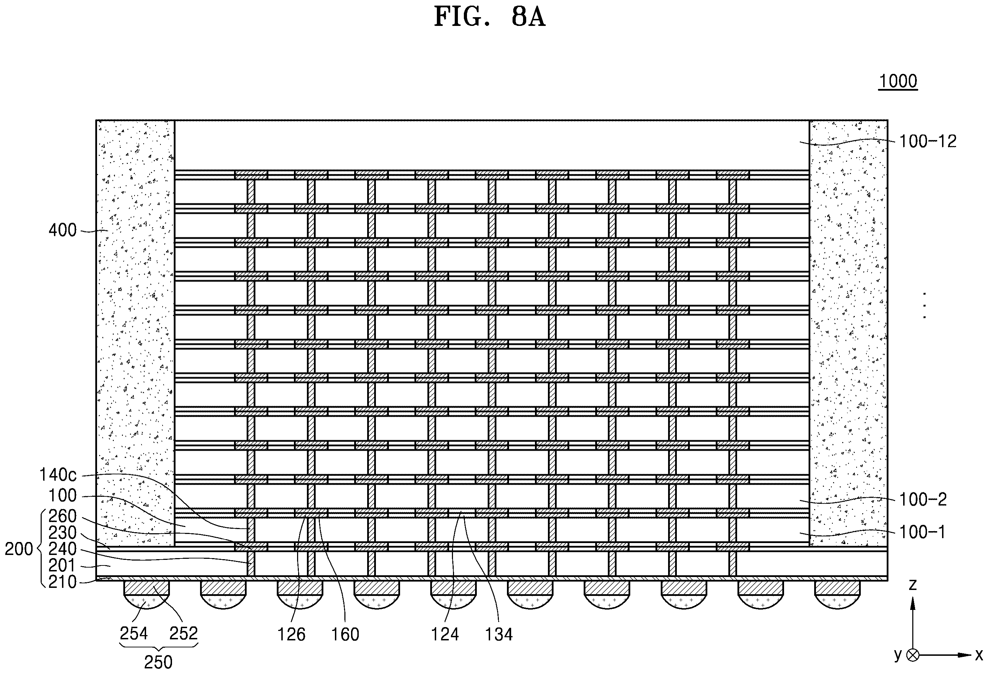

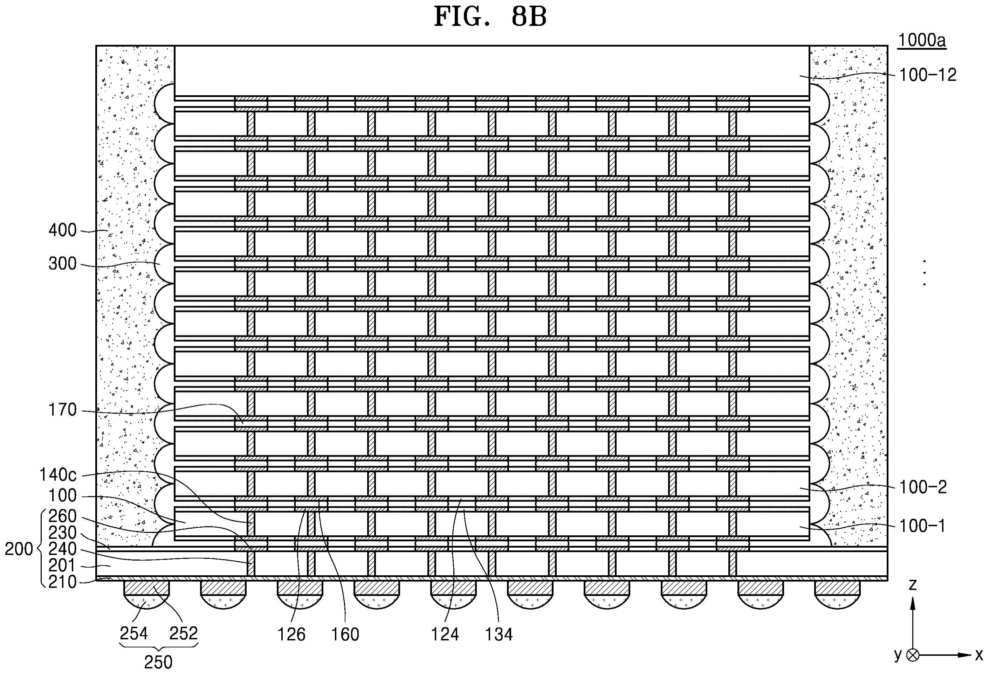

The semiconductor device 100h may be mounted on an interposer, a package substrate, or another semiconductor chip through the connection terminals. In some embodiments, the semiconductor device 100h of the current embodiment may be combined with another semiconductor chip through HCB. In such a case, the connection terminals may not be arranged on the lower pads 126. FIGS. 8A and 8B are cross-sectional views of semiconductor packages 1000 and 1000a including semiconductor devices according to embodiments.

Description will be given with reference to FIG. 7 together and the descriptions previously given with reference to FIGS. 1 to 7 are briefly given or omitted. Referring to FIG. 8A, the semiconductor package 1000 of the current embodiment may include memory chips 100, a base chip 200, and a sealant 400. The number of memory chips 100 may be, for example, 12. However, the number of memory chips 100 is not limited to 12. For example, the number of memory chips 100 may be 11 or less or 13 or more.

Each of the memory chips 100 may include memory devices in an integrated device layer. In addition, each of the memory chips 100 may include the semiconductor device 100h of FIG. 7. Accordingly, each of the memory chips 100 may include the through-electrode 140c. The through-electrode 140c may be arranged only in the device isolation layer region DIA, and the top surface of the through-electrode 140c may have substantially the same level as the top surface of the device isolation layer 150.

In addition, the top surface of the semiconductor substrate 101 may have substantially the same level as the top surface of the device isolation layer 150. In the semiconductor package 1000 of the current embodiment, the memory chip 100 may be stacked on the base chip 200 or another memory chip 100 through HCB.

As described in the description of the semiconductor device 100h of FIG. 7, the contact metal layer 160 may serve as an upper pad. Accordingly, the contact metal layer 160 of the base chip 200 or another memory chip 100 may be combined with the lower pad 126 of the memory chip 100. In addition, the protective layers 230 and 134 of the base chip 200 or another memory chip 100 may be combined with the interlayer insulating layer 124 of the wiring layer 120 of the memory chip 100. In FIG. 8A, for convenience, the integrated device layer and the wiring layer are omitted, and the through-electrode 140c is illustrated as being directly connected to the lower pad 126.

In the semiconductor package 1000 of the current embodiment, each of the memory chips 100 may include, for example, a DRAM chip, and the semiconductor package 1000 may include a high bandwidth memory (HBM) package. However, the memory chips 100 are not limited to DRAM chips. The base chip 200 may be arranged under the memory chips 100. The base chip 200 may integrate signals from the memory chips 100 and may transmit the integrated signal to the outside, and may also transmit signals and power from the outside to the memory chips 100. Accordingly, the base chip 200 may be referred to as a buffer chip or an interface chip.

In some embodiments, the base chip 200 may include a controller controlling signal transmission between the memory chips 100 and an external device. When the base chip 200 includes the controller, the base chip 200 may be referred to as a logic chip or a control chip. In addition, in some embodiments, the base chip 200 may include a power management integrated circuit (PMIC) managing power or a clock. For reference, when the base chip 200 is referred to as a buffer chip, the memory chips 100 may be referred to as core chips. The base chip 200 may have a larger size than the memory chips 100 as illustrated in FIG. 8A.

However, the size of the base chip 200 is not limited thereto. For example, in some embodiments, the base chip 200 may have substantially the same size as the memory chips 100.

The base chip 200 may include a semiconductor substrate 201, an active layer 210, a protective layer 230, a through-electrode 240, and a contact metal layer 260. The active layer 210 may include an integrated device layer and a wiring layer, and a plurality of logic elements may be arranged in the integrated device layer. The semiconductor substrate 201, the protective layer 230, the through-electrode 240, and the contact metal layer 260 are the same as described for the semiconductor substrate 101, the protective layer 134, the through-electrode 140c, and the contact metal layer 160 of the semiconductor device 100h of FIG. 7. External connection terminals 250 may be arranged on a bottom surface of the base chip 200. The external connection terminals 250 may be connected to wirings of the wiring layer of the active layer 210. In addition, the external connection terminals 250 may be connected to the through-electrode 240 through the wirings of the wiring layer. Although not shown, chip pads may be arranged on the bottom surface of the base chip 200, and the external connection terminals 250 may be arranged on the chip pads.

Each of the external connection terminals 250 may include a pillar 252 and a solder 254. The pillar 252 and the solder 254 are the same as described for the connection terminal 170 of the semiconductor device 100f of FIG. 5. The sealant 400 may surround side surfaces of the memory chips 100 on the base chip 200.

As illustrated in FIG. 8A, the sealant 400 may not cover a top surface of the uppermost memory chip, for example, a 12th memory chip 100-12. Accordingly, the top surface of the 12th memory chip 100-12 may be exposed from the sealant 400. However, in some embodiments, the sealant 400 may cover the top surface of the uppermost memory chip, for example, the 12th memory chip 100-12.

The sealant 400 may include, for example, an epoxy mold compound (EMC). However, the material of the sealant 400 is not limited to the EMC. Referring to FIG. 8B, the semiconductor package 1000a of the current embodiment may be different from the semiconductor package 1000 of FIG. 8A in that memory chips 100 are stacked through connection terminals 170. Specifically, in the semiconductor package 1000a of the current embodiment, the connection terminal 170 may be arranged on a lower pad 126 on a bottom surface of the memory chip 100. The memory chip 100 may be stacked on a base chip 200 or another memory chip 100 through the connection terminal 170. The connection terminal 170 may connect the lower pad 126 of the memory chip 100 to a contact metal layer 260 of the base chip 200 or a contact metal layer 160 of another memory chip 100.

As the memory chips 100 are stacked through the connection terminals 170, an adhesive layer 300 may be arranged between a neighboring memory chip 100 and the base chip 200, and between two adjacent memory chips 100. The adhesive layer 300 may cover the connection terminals 170. The adhesive layer 300 may include, for example, a non-conductive film (NCF). The NCF may be used, for example, as an adhesive layer when bonding semiconductor chips by a thermal compression bonding (TCB) method in a semiconductor chip stacking process. However, the material of the adhesive layer 300 is not limited to the NCF. Meanwhile, as illustrated in FIG. 8B, a side surface of the adhesive layer 300 may protrude from side surfaces of the memory chips 100.

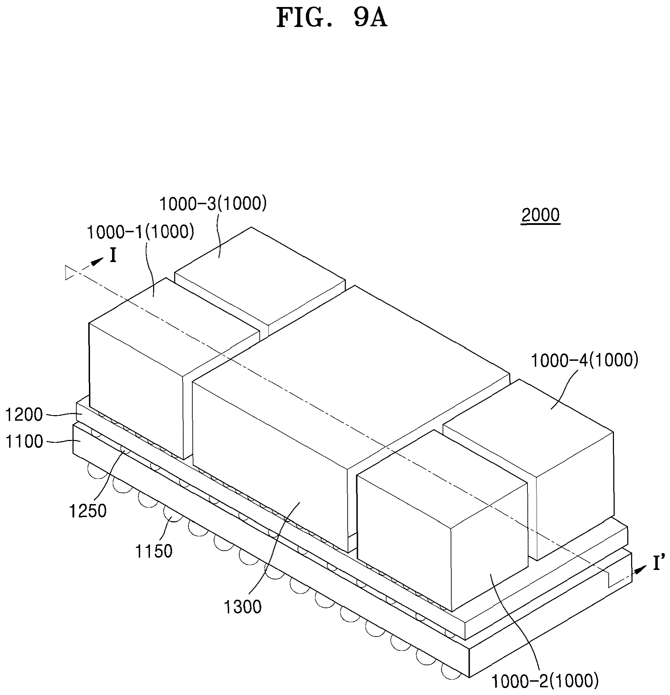

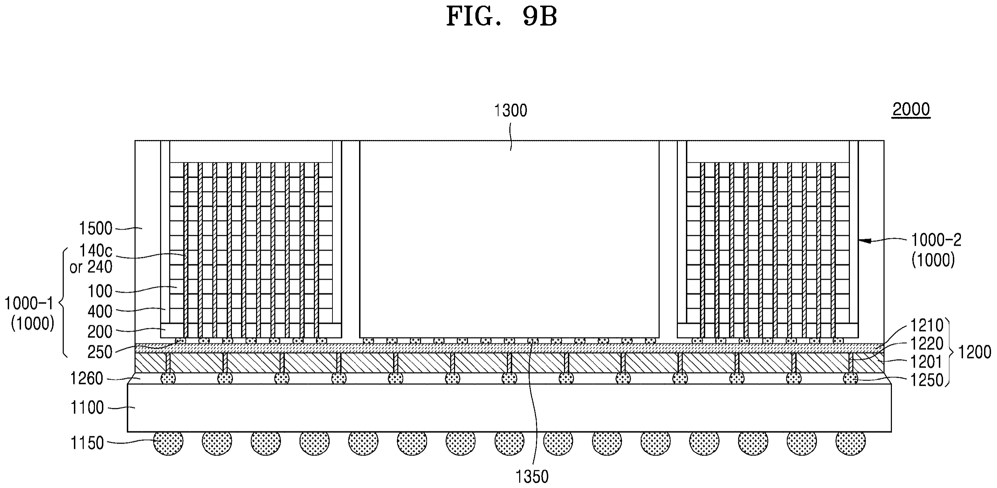

The protruding structure of the adhesive layer 300 may be naturally created due to flowability of the adhesive layer 300 when the memory chip 100 is stacked by the TCB method. FIGS. 9A and 9B are perspective and cross-sectional views of a system package 2000 including a semiconductor package 1000 according to embodiments. FIG. 9B is a cross-sectional view taken along the line I-I' of FIG. 9A. Description will be given with reference to FIGS. 1 to 8A together and the descriptions previously given with reference to FIGS. 1 to 8B are briefly given or omitted. Referring to FIGS. 9A and 9B, the system package 2000 of the current embodiment may include the semiconductor package 1000, a package substrate 1100, an interposer 1200, a semiconductor device 1300, and an external sealant 1500.

As illustrated in FIG. 9A, the semiconductor package 1000 may include first to fourth semiconductor packages 1000-1 to 1000-4. For example, two semiconductor packages 1000 may be arranged on the interposer 1200 on each side of the semiconductor device 1300. However, in the system package 2000 of the current embodiment, the number of semiconductor packages 1000 is not limited to four. For example, one to three, or five or more semiconductor packages 1000 may be arranged on the interposer 1200. The semiconductor package 1000 may include, for example, the semiconductor package 1000 of FIG. 8A.

Accordingly, the semiconductor package 1000 may include memory chips 100, a base chip 200, and a sealant 400. However, the semiconductor package 1000 is not limited to the semiconductor package 1000 of FIG. 8A.

For example, instead of the semiconductor package 1000, the semiconductor package 1000a of FIG. 8B may be applied to the system package 2000 of the current embodiment. In addition, in some embodiments, the semiconductor package 1000 may have a common semiconductor package structure.

The interposer 1200, the semiconductor package 1000, and the semiconductor device 1300 may be stacked on the package substrate 1100 as a support substrate.

The package substrate 1100 may include at least one layer of wiring lines therein. When the wiring lines include multiple layers, the wiring lines of different layers may be connected to each other through vertical vias. The package substrate 1100 may be formed based on, for example, a ceramic substrate, a printed circuit board (PCB), an organic substrate, or an interposer substrate. First connection terminals 1150 may be arranged on a bottom surface of the package substrate 1100.

The system package 2000 may be stacked on an external system board or a main board through the first connection terminals 1150. The interposer 1200 may include an interposer substrate 1201, a wiring layer 1210, a through-electrode 1220, and second connection terminals 1250. The semiconductor package 1000 and the semiconductor device 1300 may be mounted on the package substrate 1100 through the interposer 1200. The interposer 1200 may connect the semiconductor package 1000 to the semiconductor device 1300. In addition, the interposer 1200 may connect the semiconductor package 1000 and the semiconductor device 1300 to the package substrate 1100.

The interposer substrate 1201 may include, for example, Si. Accordingly, the interposer 1200 may include a Si interposer. The through-electrode 1220 may extend through the interposer substrate 1201. Because the interposer substrate 1201 includes Si, the through-electrode 1220 may correspond to a TSV. The through-electrode 1220 may extend to the wiring layer 1210 and may be connected to the wiring lines of the wiring layer 1210. According to embodiments, the interposer 1200 may include only a wiring layer and may not include a through-electrode.

The wiring layer 1210 may be arranged on a top or bottom surface of the interposer substrate 1201. For example, a positional relationship between the wiring layer 1210 and the through-electrode 1220 may be relative. Pads on a top surface of the interposer 1200 may be connected to the through-electrode 1220 through the wiring layer 1210. The second connection terminals 1250 may be arranged on a bottom surface of the interposer 1200 and may be connected to the through-electrode 1220.

The interposer 1200 may be stacked on the package substrate 1100 through the second connection terminals 1250. The second connection terminals 1250 may be connected to the pads on the top surface of the interposer 1200 through the through-electrode 1220 and the wiring lines of the wiring layer 1210. In the system package 2000 of the current embodiment, the interposer 1200 may be used for converting or transmitting an electrical signal between the semiconductor package 1000 and the semiconductor device 1300. Accordingly, the interposer 1200 may not include elements such as active elements or passive elements. However, in some embodiments, the interposer 1200 may include elements for controlling signal transmission. Meanwhile, an underfill 1260 may be filled between the interposer 1200 and the package substrate 1100 and between the second connection terminals 1250. In embodiments, the underfill 1260 may be replaced with an adhesive layer or adhesive film. The semiconductor device 1300 may be stacked on the central portion of the interposer 1200 through third connection terminals 1350. The semiconductor device 1300 may have a chip or package structure.

In the system package 2000 of the current embodiment, the semiconductor device 1300 may include one logic chip. For example, the semiconductor device 1300 may include one of the semiconductor devices 100f to 100h of FIGS. 5 to 7. In the system package 2000 of the current embodiment, the semiconductor device 1300 may include two stacked logic chips.

For example, the semiconductor device 1300 may include one of the semiconductor devices 100 and 100a to 100e of FIGS. 1 and 3 to 4D. The external sealant 1500 may cover and seal the semiconductor device 1300 and the semiconductor package 1000 on the interposer 1200. As illustrated in FIG. 9B, the external sealant 1500 may not cover top surfaces of the semiconductor device 1300 and the semiconductor package 1000. However, in embodiments, the external sealant 1500 may cover the top surface of at least one of the semiconductor device 1300 and the semiconductor package 1000. Although not shown, the system package 2000 of the current embodiment may further include a second external sealant covering and sealing the interposer 1200 and the external sealant 1500 on the package substrate 1100.

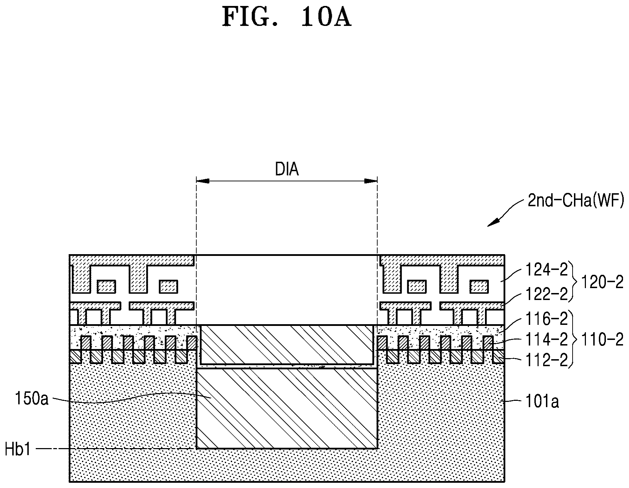

For reference, the structure of the system package 2000 of the current embodiment is called a 2.5D package structure that may be a relative concept to a 3D package structure in which all semiconductor chips are stacked together and there is no interposer. Both the 2.5D package structure and the 3D package structure may be included in a system in package (SIP) structure. In addition, the system package 2000 of the current embodiment also corresponds to a semiconductor package, but is named as a system package in order to distinguish the system package 2000 from the semiconductor package 1000 that is a component. FIGS. 10A to 10I are cross-sectional views schematically illustrating processes of a method of manufacturing a semiconductor device according to embodiments. Description will be given with reference to FIG. 1 together and the descriptions previously given with reference to FIGS. 1 to 9B are briefly given or omitted. Referring to FIG. 10A, in the semiconductor device manufacturing method of the current embodiment, first, a wafer WF including a plurality of second semiconductor chips 2nd-Cha is prepared.

Each of the second semiconductor chips 2nd-CHa may include a device isolation layer 150a, a front-end-of-line (FEOL) structure, and a back-end-of-line (BEOL) structure. Specifically, each of the second semiconductor chips 2nd-CHa may include a second semiconductor substrate 101a, a second integrated device layer 110-2, a second wiring layer 120-2, and the device isolation layer 150a. The second integrated device layer 110-2 and the second wiring layer 120-2 are the same as in the description of the semiconductor device 100 of FIG. 1. The second semiconductor substrate 101a may be thicker than the second semiconductor substrate 101-2 of the semiconductor device 100 of FIG. 1.

Accordingly, the second semiconductor substrate 101a may be maintained under the device isolation layer 150a. A through-electrode may not yet be formed in the device isolation layer 150a. The device isolation layer 150a and a portion of a second interlayer insulating layer 124-2 corresponding to the device isolation layer 150a may correspond to a device isolation layer region DIA.

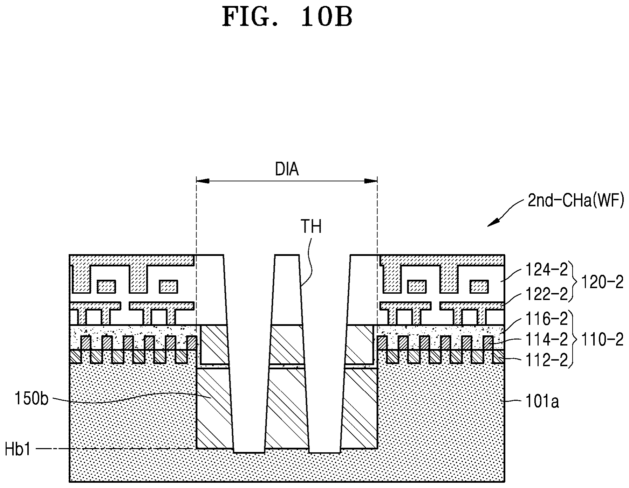

Referring to FIG. 10B, after preparing the wafer WF, a through-hole TH is formed in the device isolation layer region DIA. The through-hole TH may pass through the second interlayer insulating layer 124-2 and a device isolation layer 150b of the device isolation layer region DIA.

In an etching process of forming the through-hole TH, the second semiconductor substrate 101a may serve as an etching stopper. Accordingly, a bottom surface of the through-hole TH may be substantially the same as, or slightly lower than, a bottom surface of the device isolation layer 150b. In FIG. 10B, the bottom surface of the through-hole TH is lower than the bottom surface of the device isolation layer 150b, and accordingly, a thin recess may be formed on the second semiconductor substrate 101a by the through-hole TH. For reference, when the bottom surface of the through-hole TH is substantially the same as the bottom surface of the device isolation layer 150b, in the final structure, a bottom surface of a through-electrode 140 may be higher than the bottom surface of the device isolation layer 150b by a thickness of an insulating liner 146.

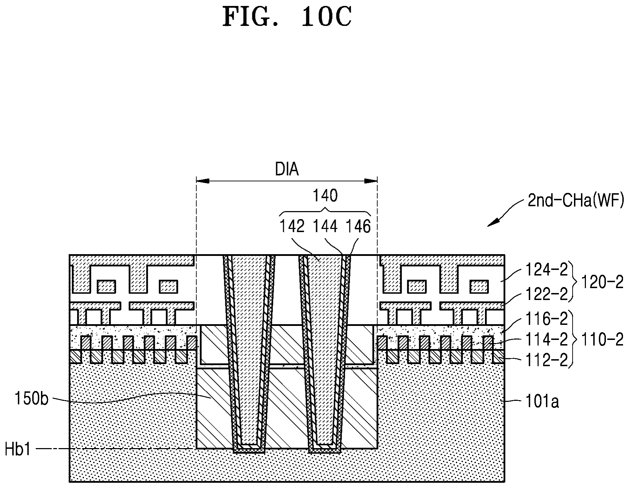

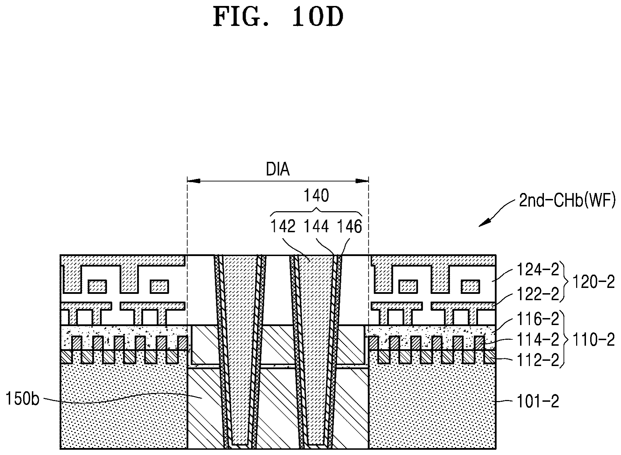

Referring to FIG. 10C, after forming the through-hole TH, the insulating liner 146, a barrier metal 144, and an electrode metal 142 are sequentially filled in the through-hole TH to form the through-electrode 140. The structure and material of the through-electrode 140 are the same as in the description of the semiconductor device 100 of FIG. 1. Referring to FIG. 10D, after forming the through-electrode 140, a lower portion of the second semiconductor substrate 101a is removed. For example, the lower portion of the second semiconductor substrate 101a may be removed by a grinding and chemical mechanical polishing (CMP) process after attaching a top surface of the wafer WF to a carrier wafer.

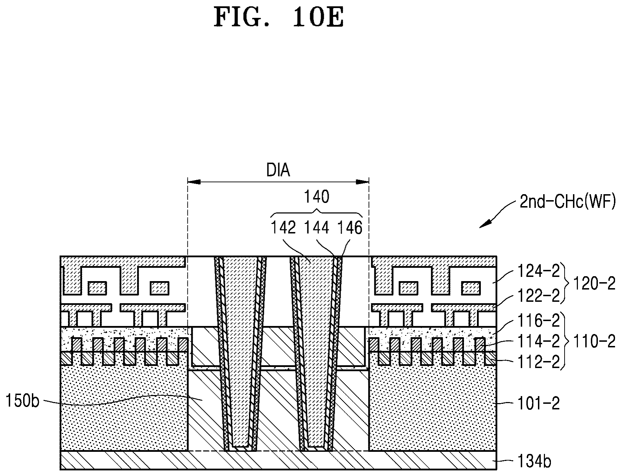

In the CMP process, the device isolation layer 150b may serve as a stopper. Meanwhile, in the grinding and CMP process, the insulating liner 146 on the bottom surface of the through-electrode 140 may be removed. By removing the lower portion of the second semiconductor substrate 101a, a thickness of the second semiconductor substrate 101-2 of the second semiconductor chip 2nd-CHb may be made the same as a thickness of the second semiconductor substrate 101-2 of the semiconductor device 100 of FIG. 1. Referring to FIG. 10E, after removing the lower portion of the second semiconductor substrate 101a, a lower insulating layer 134b is formed on the bottom surface of the second semiconductor substrate 101-2 and the device isolation layer 150b. The lower insulating layer 134b may include, for example, an oxide layer. A second semiconductor chip 2nd-CHc may include the lower insulating layer 134b on the bottom surface of the second semiconductor substrate 101-2.

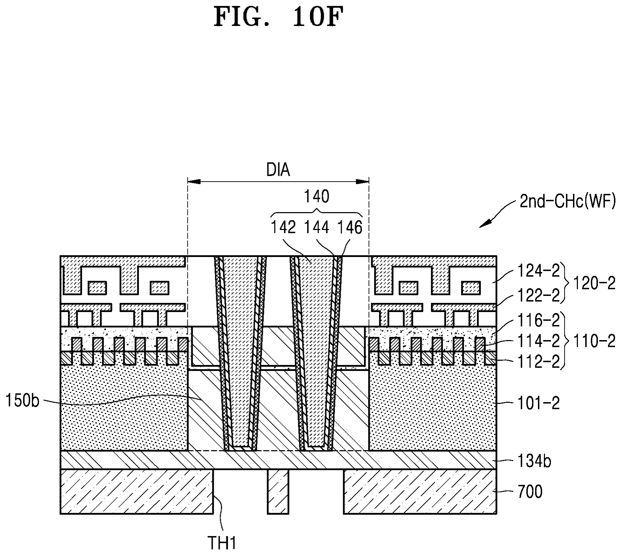

Referring to FIG. 10F, a photoresist pattern 700 is then formed on the lower insulating layer 134b. The photoresist pattern 700 may include a first through-hole TH1.

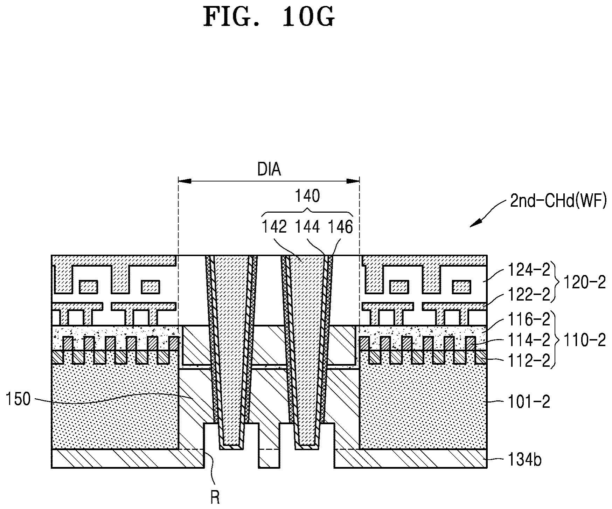

The first through-hole TH1 may be formed at a position corresponding to the through-electrode 140. Referring to FIG. 10G, after forming the photoresist pattern 700, lower portions of the lower insulating layer 134b and the device isolation layer 150b are etched by using the photoresist pattern 700 as an etching mask. Through etching, a recess R may be formed in the lower portions of the lower insulating layer 134b and the device isolation layer 150 to expose the bottom surface and the side surface adjacent to the bottom surface of the through-electrode 140. Meanwhile, in the etching process, the insulating liner 146 of the through-electrode 140 may also be etched, so that the barrier metal 144 of the through-electrode 140 may be exposed in the recess R.

The second semiconductor chip 2nd-CHd may include the recess R on a bottom surface of the device isolation layer region DIA.

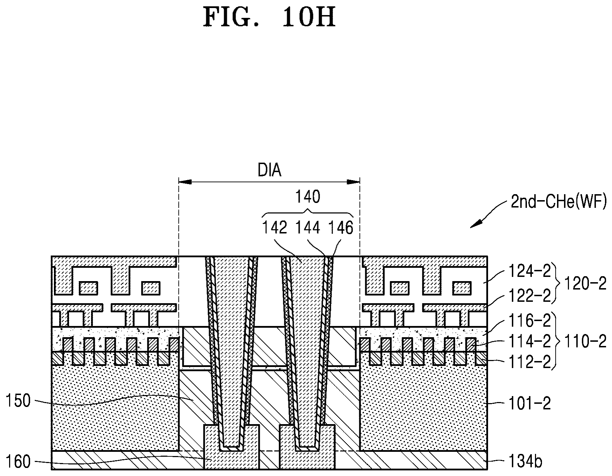

Referring to FIG. 10H, after forming the recess R, a metal is filled in the recess R to form a contact metal layer 160. To correspond to the shape of the recess R, the contact metal layer 160 may have an around metal structure. When the recess R is formed thinly to expose only the bottom surface of the through-electrode 140, the contact metal layer 160 may have a pad metal structure.

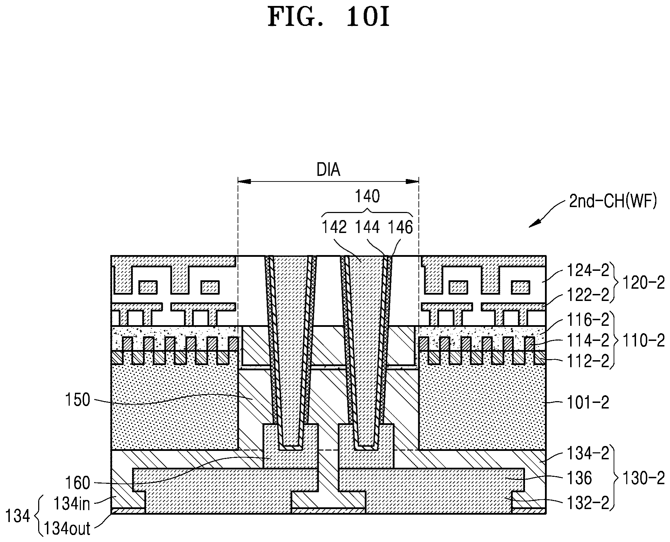

A second semiconductor chip 2nd-CHe may include the contact metal layer 160 under the device isolation layer region DIA. Referring to FIG. 10I, after forming the contact metal layer 160, a pad redistribution layer 136 and a second pad 132-2 may be formed under the contact metal layer 160 to complete the second semiconductor chip 2nd-CH. In addition, when forming the pad redistribution layer 136 and the second pad 132-2, the BSPDN layer may be formed together to complete the semiconductor device 100g of FIG. 6.

Thereafter, a wafer WF including second semiconductor chips 2nd-CH is stacked on a lower wafer including first semiconductor chips 1st-CH through HCB. In some embodiments, the wafer WF may be stacked on the lower wafer by using connection terminals and an adhesive layer. After stacking the wafer WF on the lower wafer, semiconductor devices may be completed through individualization through a sawing process.

So far, the inventive concept has been described with reference to the embodiments illustrated in the drawings, which are only examples.
Therefore, a person having ordinary skill in the art will understand that various modifications and equivalent embodiments are possible. Therefore, the true technical protection scope of the inventive concept should be determined by the technical idea of the appended claims.

While the inventive concept has been particularly shown and described with reference to embodiments thereof, it will be understood that various changes in form and details may be made therein without departing from the scope of the following claims.

## Claims

1. A semiconductor device (100) including a through-electrode (140), the semiconductor device (100) comprising:
a first semiconductor chip (1st-CH) including a first semiconductor substrate (101-1), a first integrated device layer (110-1), and a first wiring layer (120-1); and
a second semiconductor chip (2nd-CH) stacked on the first semiconductor chip (1st-CH) and including a second semiconductor substrate (101-2), a second integrated device layer (110-2), a second wiring layer (120-2), and a through-electrode (140),
wherein:
the second semiconductor chip (2nd-CH) comprises a device isolation layer (150) isolating the second integrated device layer (110-2), and
the through-electrode (140) passes through the device isolation layer (150), and a level of a bottom surface of the through-electrode (140) is higher than or the same as a level of a bottom surface of the device isolation layer (150).

2. The semiconductor device (100) of claim 1, wherein a level of a bottom surface of the second semiconductor substrate (101-2) is the same as a level of a bottom surface of the device isolation layer (150).

3. The semiconductor device (100) of claim 1 or claim 2, wherein at least one through-electrode (140) is arranged in the device isolation layer (150).

4. The semiconductor device (100) of any preceding claim,
wherein:
a plurality of through-electrodes (140) are arranged in the one device isolation layer (150), and
a level of a top or bottom surface of at least one of the plurality of through-electrodes (140) is different from a level of a top or bottom surface of another through-electrode (140).

5. The semiconductor device (100) of any preceding claim,
wherein:
a pad redistribution layer (136) is arranged under the second semiconductor substrate (101-2), and
wherein a contact metal layer (160) connected to the through-electrode (140) is arranged on a top surface of the pad redistribution layer (136).

6. The semiconductor device (100) of claim 5, wherein the contact metal layer (160) surrounds a bottom surface of the through-electrode (140) and a side surface adjacent to the bottom surface of the through-electrode (140).

7. The semiconductor device (100) of claim 5 or claim 6,
wherein:
a first pad (132-1) and a first protective layer (134-1) surrounding the first pad (132-1) are arranged on the first wiring layer (120-1),
a second pad (132-2) and a second protective layer (134-2) surrounding the second pad (132-2) are arranged on a bottom surface of the pad redistribution layer (136), and
the first semiconductor chip (1st-CH) is combined with the second semiconductor chip (2nd-CH) by hybrid copper bonding (HCB) through a combination of the first pad (132-1) with the second pad (132-2) and a combination of the first protective layer (134-1) with the second protective layer (134-2).

8. The semiconductor device (100) of any preceding claim, wherein the through-electrode (140) comprises an electrode metal (142), a barrier metal (144) on the electrode metal (142), and an insulating liner (146) on the barrier metal (144), or an electrode metal (142), and a barrier metal (144) on the electrode metal (142).

9. A method of manufacturing a semiconductor device (100) comprising:
preparing a first wafer including a first semiconductor substrate (101-1), a first integrated device layer (110-1), a first wiring layer (120-1), and a device isolation layer (150);
forming a through-hole (TH) in the device isolation layer (150);
forming a through-electrode (140) in the through-hole (TH);
removing a lower portion of the first semiconductor substrate (101-1);
forming a first insulating layer (116-1) under the first semiconductor substrate (101-1);
forming a recess (R) exposing a lower portion of the through-electrode (140) in the first insulating layer (116-1);
forming a contact metal layer (160) in the recess (R); and
forming a pad redistribution layer (136) connected to the contact metal layer (160) and a first pad (132-1).

10. The method of claim 9, wherein in the forming of the through-hole (TH), the first semiconductor substrate (101-1) is used as an etching stop layer.

11. The method of claim 9 or claim 10,
wherein the forming of the through-electrode (140) comprises:
coating the through-hole (TH) with a barrier metal; and
forming a metal electrode layer on the barrier metal in the through-hole (TH).

12. The method of any of claims 9-11,
wherein in the removing of the lower portion of the first semiconductor substrate (101-1), a lower portion of the first semiconductor substrate (101-1) is removed through a grinding and chemical mechanical polishing (CMP) process and the device isolation layer (150) is used as an etching stop layer.

13. The method of any of claims 9-12,
wherein the recess (R) exposes a bottom surface of the through-electrode (140) and a side surface adjacent to the bottom surface of the through-electrode (140), and
the contact metal layer (160) surrounds the bottom surface of the through-electrode (140) and the side surface adjacent to the bottom surface of the through-electrode (140).

14. The method of any of claims 9-13,
further comprising bonding a second device wafer to a first device wafer,
wherein the first device wafer is completed through the forming of the pad redistribution layer (136) and a first pad (132-1).

15. The method of any of claims 9-14,
wherein in the forming of the pad redistribution layer (136) and the first pad (132-1), a back-side power delivery network (BSPDN) layer (180) is formed under the first semiconductor substrate (101-1).

## Amended claims

### Amended claims in accordance with Rule 137(2) EPC.

1. A semiconductor device (100) including a through-electrode (140), the semiconductor device (100) comprising:
a first semiconductor chip (1st-CH) including a first semiconductor substrate (101-1), a first integrated device layer (110-1), and a first wiring layer (120-1); and
a second semiconductor chip (2nd-CH) stacked on the first semiconductor chip (1st-CH) and including a second semiconductor substrate (101-2), a second integrated device layer (110-2), a second wiring layer (120-2), and a through-electrode (140),
wherein:
the second semiconductor chip (2nd-CH) comprises a device isolation layer region (DIA) including a device isolation layer (150) isolating the second integrated device layer (110-2), wherein the device isolation layer region isolates the second integrated device layer (110-2) and the second wiring layer (120-2),
the through-electrode (140) passes through the device isolation layer (150), and a level of a bottom surface of the through-electrode (140) is higher than or the same as a level of a bottom surface of the device isolation layer (150),
the through-electrode (140) is located only in the device isolation layer region (DIA).

2. The semiconductor device (100) of claim 1, wherein a level of a bottom surface of the second semiconductor substrate (101-2) is the same as a level of a bottom surface of the device isolation layer (150).

3. The semiconductor device (100) of claim 1 or claim 2, wherein at least one through-electrode (140) is arranged in the device isolation layer (150).

4. The semiconductor device (100) of any preceding claim,
wherein:
a plurality of through-electrodes (140) are arranged in the one device isolation layer (150), and
a level of a top or bottom surface of at least one of the plurality of through-electrodes (140) is different from a level of a top or bottom surface of another through-electrode (140).

5. The semiconductor device (100) of any preceding claim,
wherein:
a pad redistribution layer (136) is arranged under the second semiconductor substrate (101-2), and
wherein a contact metal layer (160) connected to the through-electrode (140) is arranged on a top surface of the pad redistribution layer (136).

6. The semiconductor device (100) of claim 5, wherein the contact metal layer (160) surrounds a bottom surface of the through-electrode (140) and a side surface adjacent to the bottom surface of the through-electrode (140).

7. The semiconductor device (100) of claim 5 or claim 6,
wherein:
a first pad (132-1) and a first protective layer (134-1) surrounding the first pad (132-1) are arranged on the first wiring layer (120-1),
a second pad (132-2) and a second protective layer (134-2) surrounding the second pad (132-2) are arranged on a bottom surface of the pad redistribution layer (136), and
the first semiconductor chip (1st-CH) is combined with the second semiconductor chip (2nd-CH) by hybrid copper bonding (HCB) through a combination of the first pad (132-1) with the second pad (132-2) and a combination of the first protective layer (134-1) with the second protective layer (134-2).

8. The semiconductor device (100) of any preceding claim, wherein the through-electrode (140) comprises an electrode metal (142), a barrier metal (144) on the electrode metal (142), and an insulating liner (146) on the barrier metal (144), or an electrode metal (142), and a barrier metal (144) on the electrode metal (142).

9. A method of manufacturing a semiconductor device (100) comprising:
preparing a first wafer for a first semiconductor chip (1st-CH), the first wafer including a first semiconductor substrate (101-1), a first integrated device layer (110-1), and a first wiring layer (120-1),
preparing a second wafer for a second semiconductor chip (2nd-CH), the second wafer including a second semiconductor substrate (101-2), and a device isolation layer region (DIA) including a device isolation layer (150);
forming a through-hole (TH) in the device isolation layer (150);
forming a through-electrode (140) in the through-hole (TH), the through-electrode (140) located only in the device isolation layer region (DIA);
removing a lower portion of the first semiconductor substrate (101-1);
forming a first insulating layer (116-1) under the first semiconductor substrate (101-1);
forming a recess (R) exposing a lower portion of the through-electrode (140) in the first insulating layer (116-1);
forming a contact metal layer (160) in the recess (R); and
forming a pad redistribution layer (136) connected to the contact metal layer (160) and a first pad (132-1)
stacking the second semiconductor chip (2nd-CH) on the first semiconductor chip (1st-CH),
wherein the device isolation layer region isolates a second integrated device layer (110-2) and a second wiring layer (120-2) of the second semiconductor chip (2nd-CH).

10. The method of claim 9, wherein in the forming of the through-hole (TH), the first semiconductor substrate (101-1) is used as an etching stop layer.

11. The method of claim 9 or claim 10,
wherein the forming of the through-electrode (140) comprises:
coating the through-hole (TH) with a barrier metal; and
forming a metal electrode layer on the barrier metal in the through-hole (TH).

12. The method of any of claims 9-11,
wherein in the removing of the lower portion of the first semiconductor substrate (101-1), a lower portion of the first semiconductor substrate (101-1) is removed through a grinding and chemical mechanical polishing (CMP) process and the device isolation layer (150) is used as an etching stop layer.

13. The method of any of claims 9-12,
wherein the recess (R) exposes a bottom surface of the through-electrode (140) and a side surface adjacent to the bottom surface of the through-electrode (140), and
the contact metal layer (160) surrounds the bottom surface of the through-electrode (140) and the side surface adjacent to the bottom surface of the through-electrode (140).

14. The method of any of claims 9-13,
further comprising bonding a second device wafer to a first device wafer,
wherein the first device wafer is completed through the forming of the pad redistribution layer (136) and a first pad (132-1).

15. The method of any of claims 9-14,
wherein in the forming of the pad redistribution layer (136) and the first pad (132-1), a back-side power delivery network (BSPDN) layer (180) is formed under the first semiconductor substrate (101-1).
